# EUROPEAN PATENT APPLICATION

(11) **EP 4 746 632 A1**
(43) Date of publication of application: **20.05.2026**
(21) Application number: 24839396.9
(22) Date of filing: 12.06.2024
(51) Int. Cl.: H10D 48/40

(54) **LOGICAL OPERATION ELEMENT, LOGIC DEVICE, NOT LOGIC DEVICE, SWITCHABLE NOT LOGIC DEVICE, XOR LOGIC DEVICE, AND LOGIC DEVICE, OR LOGIC DEVICE, AND HALF ADDER**

(30) Priority: 11.07.2023 JP 2023113508
(71) Applicant: Japan Science and Technology Agency, Kawaguchi-shi, Saitama 332-0012 (JP)
(72) Inventor: KOHDA, Makoto, Sendai-shi Miyagi 980-8577 (JP); KARUBE, Shutaro, Sendai-shi Miyagi 980-8577 (JP); ZHANG, Chao Liang, Sendai-shi Miyagi 980-8577 (JP); KIKUCHI, Keito, Sendai-shi Miyagi 980-8577 (JP); NAKAJIMA, Kai, Sendai-shi Miyagi 980-8577 (JP)
(74) Representative: Noble, Nicholas
(86) International application number: PCT/JP2024/021394
(87) International publication number: WO 2025/013500

(57) **Abstract**

The logic operation element 1A comprises a one-dimensional wire structure 10 through which an electron spin wave propagates and a gate electrode 20A along part of the one-dimensional wire structure 10. The logic input of the logic operation element 1A is the phase state of the electron spin wave before propagating through the one-dimensional wire structure 10. The logic output of the logic operation element 1A is the phase state of the electron spin wave after propagation through the one-dimensional wire structure 10.

## Description

### TECHNICAL FIELD

This invention relates to a logic operation element, a logic device, a NOT logic device, a switchable NOT logic device, a XOR logic device, an AND logic device, an OR logic device and a half-adder.

### BACKGROUND ART

Majority logic devices using electron spin waves, produced by sustained spin precession of free electron due to an effective magnetic field are known. For example, a majority logic device using spin polarization information of Persistent Spin Helix, i.e., PSH, generated in a two-dimensional electron gas is disclosed, e.g., Patent Literature 1. Also disclosed is a technique for switching the electron spin wave between Persistent Spin Helix and inverse Persistent Spin helix, i.e., iPSH, by gate voltage in a wire structure of quantum wells, e.g., Non Patent Literature 1.

### RELATED-ART LITERATURE

### PATENT LITERATURE

Patent Literature 1: Japanese Patent Publication. 2015-518267

### NON PATENT LITERATURE

Non Patent Literature 1: "Gate-controlled switching between persistent and inverse persistent spin helix states", K. Yoshizumi, A. Sasaki, M. Kohda and J. Nitta", APPLIED PHYSICS LETTERS 108, 132402 (2016)

### SUMMARY OF INVENTION

### TECHNICAL PROBLEM

Conventionally, for an optical input signal, the signal was converted into an electrical signal by photoelectric conversion, digitized according to high and low voltage levels, and a logic operation was performed. In this case, processing based on wave interference could not be performed after photoelectric conversion.

The present invention was made in view of the aforementioned problems and a general purpose thereof is to realize a logic device that can perform logic operations and processes such as majority logic operations based on wave interference without restrictions by means of high and low voltage levels while maintaining the interference nature of the wave on the optical input signals.

### SOLUTION TO PROBLEM

In order to solve the above problem, a logic operation element according to a certain aspect of the disclosure comprises a through which an electron spin wave propagates and a gate electrode along part of the . The logic input is the phase state of the electron spin wave before propagating through the one-dimensional wire structure. The logic output is the phase state of the electron spin wave after propagation through the one-dimensional wire structure.

In one embodiment, in the logic operation element, the one-dimensional wire structure may comprise a material that, upon irradiation of light having a predetermined polarization state, generates an electron spin wave having a phase corresponding to the polarization state. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. In the one-dimensional wire structure, a gate electrode section along the gate electrode is positioned between the spin wave generator and the output section. The distance between the spin wave generator and the output section is approximately an integer multiple of the wavelength of the electron spin wave. The length of the gate electrode is approximately an odd multiple of the half wavelength of the electron spin wave. The width of the one-dimensional wire structure is smaller than half the wavelength of the electron spin wave. The electron spin wave before entering the gate electrode section from the spin wave generator is in the iPSH state or the PSH state. The gate electrode can apply a gate voltage that makes the electron spin wave at the gate electrode section into the PSH state when the electron spin wave before entering the gate electrode section from the spin wave generator is in the iPSH state. The gate electrode can apply a gate voltage that makes the electron spin wave at the gate electrode section into the iPSH state when the electron spin wave before entering the gate electrode section from the spin wave generator is in the PSH state. Namely, this embodiment is a NOT logic device comprising aforementioned logic operation element. The logic input is the phase state of the electron spin wave at the spin wave generator. The logic output is the phase state of the electron spin wave at the output section.

This NOT logic device comprises a one-dimensional wire structure and a gate electrode. The one-dimensional wire structure comprises a spin wave generator and an output section. The spin wave generator either generates electron spin waves by irradiating electrons with optical signals or is input electron spin waves output from an adjacent one-dimensional wire structure. The output section outputs the electron spin wave that has propagated through the one-dimensional wire structure. In the latter case, the output section of the adjacent one-dimensional wire structure serves as the spin wave generator of the one-dimensional wire structure. The gate electrode is positioned between the spin wave generator and the output section along the one-dimensional wire structure. The one-dimensional wire structure is made of a material that generates electron spin waves with a phase corresponding to a predetermined polarization state upon irradiation of light having a predetermined polarization state. The spin wave generator generates electron spin waves by irradiating electrons with optical signals. The output section outputs the electron spin wave propagated through the one-dimensional wire structure.

In a logic operation element according to one embodiment, the one-dimensional wire structure may comprise a material that, upon irradiation of light having a predetermined polarization state, generates an electron spin wave having a phase corresponding to the polarization state. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. In the one-dimensional wire structure, a gate electrode section along the gate electrode is positioned between the spin wave generator and the output section. The distance between the spin wave generator and the output section is approximately an integer multiple of the wavelength of the electron spin wave. The length of the gate electrode is approximately an odd multiple of the half wavelength of the electron spin wave. The width of the one-dimensional wire structure is smaller than half the wavelength of the electron spin wave. The electron spin wave before entering the gate electrode section from the spin wave generator is in the iPSH state or the PSH state. This logic device further comprises a switch that switches the voltage applied to the gate electrode between a first gate voltage that makes the electron spin wave into the PSH state and a second gate voltage that makes the electron spin wave into the iPSH state. Namely, this embodiment is a switchable NOT logic device that is switchable between NOT logic and identity logic by the switch. The logic input is the phase state of the electron spin wave at the spin wave generator. The logic output is the phase state of the electron spin wave at the output section.

This switchable NOT logic device comprises a one-dimensional wire structure and a gate electrode.
The one-dimensional wire structure comprises a spin wave generator and an output section. The gate electrode comprises a switch that switches the gate voltage applied to the gate electrode between a first gate voltage that makes the electron spin wave into the PSH state and a second gate voltage that makes the electron spin wave into the iPSH state. When the switch is at the first gate voltage, the switchable NOT logic device is substantially the same as the NOT logic device described above. On the other hand, when the switch is at the second gate voltage, in this switchable NOT logic device, the same logic value as the logic value at the spin wave generator is output from the output section.

One embodiment may be configured as an XOR logic device comprising two switchable NOT logic devices. The two switchable NOT logic devices are connected in the first stage and the second stage in series. The spin wave generator of the switchable NOT logic device in the first stage is the overall spin wave generator. The output section of the switchable NOT logic device in the first stage is common to the spin wave generator of the switchable NOT logic device in the second stage. The output section of the switchable NOT logic device in the second stage is the overall output section. The logic input is whether the voltage applied to the gate electrodes of the two switchable NOT logic devices is the first gate voltage to make the electron spin wave into the PSH state or the second gate voltage to make the electron spin wave into the iPSH state. The logic output is the phase state of the electron spin wave at the overall output section.

This XOR logic device comprises a one-dimensional wire structure, a first gate electrode and a second gate electrode. The one-dimensional wire structure comprises a material that, upon irradiation of light having a predetermined polarization state, generates an electron spin wave having a phase corresponding to the polarization state. The first gate electrode and the second gate electrode can apply a first gate voltage that makes the electron spin wave into the PSH state or a second gate voltage that makes the electron spin wave into the iPSH state to part of the one-dimensional wire structure. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. The distance between the spin wave generator and the output section is approximately an integer multiple of the wavelength of the electron spin wave. The length of the first gate electrode and the length of the second gate electrode are each approximately odd multiples of the half-wavelength of the electron spin wave. The width of the one-dimensional thin line structure is smaller than the half-wavelength of the electron spin wave. The first gate electrode and the second gate electrode each have a switch that switches the applied gate voltage between the first gate voltage and the second gate voltage. The first gate electrode and the second gate electrode are positioned in series along the one-dimensional wire structure.

One embodiment may be configured as an AND logic device comprising the above two switchable NOT logic devices and one one-dimensional wire structure. This AND logic device comprises two switchable NOT logic devices and one one-dimensional wire structure connected in parallel. The two switchable NOT logic devices and the one one-dimensional wire structure share the common spin wave generator. The two switchable NOT logic devices and the one one-dimensional wire structure share the common output section. The logic input is whether the voltage applied to the gate electrodes of the two switchable NOT logic devices is the first gate voltage that makes the electron spin wave into the PSH state or the second gate voltage that makes the electron spin wave into the iPSH state. The logic output is the phase state of the electron spin wave at the output section.

This AND logic device comprises a first switchable NOT logic device, a second switchable NOT logic device and one one-dimensional wire structure, connected in parallel. The first switchable NOT logic device and the second switchable NOT logic device are the switchable NOT logic devices described above. The spin wave generator of the first switchable NOT logic device, the spin wave generator of the second switchable NOT logic device and the spin wave generator of the one one-dimensional wire structure are common. The output section of the first switchable NOT logic device, the output section of the second switchable NOT logic device and the output section of the one one-dimensional wire structure are common.

One embodiment may be configured as an OR logic device comprising the above two switchable NOT logic devices and the above one NOT logic device. This OR logic device comprises the two switchable NOT logic devices and the one NOT logic device connected in parallel. The spin wave generators of the two switchable NOT logic devices and the spin wave generator of the one NOT logic device are common. The output sections of the two switchable NOT logic devices and the output section of the one NOT logic device are common. The logic input is whether the voltage applied to the gate electrodes of the two switchable NOT logic devices is the first gate voltage that makes the electron spin wave into the PSH state or the second gate voltage that makes the electron spin wave into the iPSH state. The logic output is the phase state of the electron spin wave at the output section.

This OR logic device comprises a first switchable NOT logic device, a second switchable NOT logic device and one NOT logic device connected in parallel. The first switchable NOT logic device and the second switchable NOT logic device are the aforementioned switchable NOT logic devices. The first switchable NOT logic device, the second switchable NOT logic device and the one NOT logic device share the same spin wave generator. The output sections of the first switchable NOT logic device, the second switchable NOT logic device and the one NOT logic device are common.

One embodiment may be configured as a half-adder comprising the AND logic device described above and the XOR logic device described above. This half-adder comprises the AND logic device and the XOR logic device connected in parallel. The spin wave generator of the AND logic device and the spin wave generator of the XOR logic device are common. The output section of the AND logic device and the output section of the XOR logic device are separate. One of 1-bit binary inputs to be added is whether the voltage applied to the gate electrodes of the two switchable NOT logic devices of the AND logic device is the first gate voltage that makes the electron spin wave into the PSH state or the second gate voltage that makes the electron spin wave into the iPSH state. The upper bit of the 2-bit binary output is the phase state of the electron spin wave at the output section of the AND logic device. The 1-bit binary inputs to be added is whether the voltage applied to the gate electrodes of the two switchable NOT logic devices of the XOR logic device is the first gate voltage or the second gate voltage. The lower bit of the 2-bit binary output is the phase state of the electron spin wave at the output section of the XOR logic device.

Namely, the logic operation element according to this embodiment is a half-adder. This half adder comprises a first AND logic device and a second XOR logic device connected in parallel. The first AND logic device is the AND logic device described above. The second XOR logic device is the XOR logic device described above. The phase state of the electron spin wave output from the output section of the first AND logic device represents the upper bits of a 2-bit binary number. The phase state of the electron spin wave output from the output section of the second XOR logic device represents the lower bits of the 2-bit binary number.

Yet another aspect of the disclosure is a logic operation element. This logic operation element comprises a one-dimensional wire structure through which an electron spin wave propagates and a gate electrode along part of the one-dimensional wire structure. The logic input is the high and low of the gate voltage applied to the gate electrode. The logic output is the phase state of the electron spin wave.

In a logic operation element according to one embodiment, the one-dimensional wire structure comprises a material that, upon irradiation of light having a predetermined polarization state, generates an electron spin wave having a phase corresponding to the polarization state. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. In the one-dimensional wire structure, a gate electrode section along the gate electrode is positioned between the spin wave generator and the output section. The distance between the spin wave generator and the output section is approximately an integer multiple of the wavelength of the electron spin wave. The length of the gate electrode is approximately an odd multiple of the half wavelength of the electron spin wave. The width of the one-dimensional wire structure is smaller than half the wavelength of the electron spin wave. The electron spin wave before entering the gate electrode section from the spin wave generator is in the iPSH state or the PSH state. The gate electrode can apply a first gate voltage that makes the electron spin wave into the PSH state and a second gate voltage that makes the electron spin wave into the iPSH state.

In a logic operation element according to one embodiment, the one-dimensional wire structure comprises a material that, upon irradiation of light having a predetermined polarization state, generates an electron spin wave having a phase corresponding to the polarization state. The gate electrode comprises a first gate electrode and a second gate electrode. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. In the one-dimensional wire structure, a first gate electrode section along a first gate electrode and a second gate electrode section along a second gate electrode are positioned in series between the spin wave generator and the output section. The distance between the spin wave generator and the output section is approximately an integer multiple of the half wavelength of the electron spin wave. The lengths of the first gate electrode and the second gate electrode are each approximately odd multiples of the half wavelength of the electron spin wave. The distance between the first gate electrode and the second gate electrode is approximately an integer multiple of the wavelength of the electron spin wave. The width of the one-dimensional wire structure is smaller than half the wavelength of the electron spin wave. The electron spin wave before entering the first gate electrode section from the spin wave generator is in the iPSH state or the PSH state. The first gate electrode and the second gate electrode can apply a first gate voltage that makes the electron spin wave into the PSH state and a second gate voltage that makes the electron spin wave into the iPSH state, respectively.

Yet another aspect of the disclosure is a logic device. This logic device comprises a logic operation element described above and a majority logic element. The logic input is phase states of a plurality of electron spin waves. The logic output is the phase state of the electron spin wave on which the plurality of electron spin waves are multiplexed. The majority logic element comprises a one-dimensional wire structure through which an electron spin wave propagates and a two-dimensional wire structure. The two-dimensional wire structure comprises a branching point at which the one-dimensional wire structure branches to form two or more branching wires and a junction point at which the two or more branching wires merge to form a single one-dimensional wire structure.

In a logic operation element according to one embodiment, the one-dimensional wire structure comprises a material that, upon irradiation of light having a predetermined polarization state, generates an electron spin wave having a phase corresponding to the polarization state. At the branching point, the one-dimensional wire structure branches to form three branching wires of a first branching wire, a second branching wire and a third branching wire. At the junction point, three branching wires merge to form a single one-dimensional wire structure. The logic device further comprises a first logic operation element and a second logic operation element. The first logic operation element comprises part of the first branching wire and a first gate electrode along the part of the first branching wire. The second logic operation element comprises part of the second branching wire and a second gate electrode along the part of the second branching wire. The two-dimensional wire structure comprises a spin wave generator and an output section. The spin wave generator either generates electron spin waves by irradiating electrons in the two-dimensional wire structure at or before the branching point with optical signals or is input electron spin waves output from an adjacent one-dimensional wire structure. The output section outputs an electron spin wave on which the electron spin wave propagated through the first branching wire, the electron spin wave propagated through the second branching wire and the electron spin wave propagated through the third branching wire at or after junction point are multiplexed. The distance between the spin wave generator and the output section is approximately an integer multiple of the half-wavelength of the electron spin wave. In the first branching wire, a first gate electrode section is positioned along the first gate electrode. In the second branching wire, a second gate electrode section is positioned along the second gate electrode. The lengths of the first gate electrode and the second gate electrode are approximately odd multiples of the half-wavelength of the electron spin wave. The width of the one-dimensional wire structure is smaller than the half-wavelength of the electron spin wave. The electron spin wave before entering the first gate electrode section and the second gate electrode section from the spin wave generator is in the iPSH state or the PSH state. The first gate electrode and the second gate electrode respectively can apply a first gate voltage that makes the electron spin wave into the PSH state and a second gate voltage that makes the electron spin wave into the iPSH state.

In a logic operation element according to one embodiment, the one-dimensional wire structure comprises a material that, upon irradiation of light having a predetermined polarization state, generates an electron spin wave having a phase corresponding to the polarization state, wherein at the branching point, the one-dimensional wire structure branches to form three branching wires of a first branching wire, a second branching wire and a third branching wire. At the junction point, three branching wires merge to form a single one-dimensional wire structure. The logic device further comprises a first logic operation element, a second logic operation element and a third logic operation element. The first logic operation element comprises part of the first branching wire and a first gate electrode along the part of the first branching wire. The second logic operation element comprises part of the second branching wire and a second gate electrode along the part of the second branching wire. The third logic operation element comprises part of the third branching wire and a third gate electrode along the part of the third branching wire. The two-dimensional wire structure comprises a spin wave generator and an output section. The spin wave generator either generates electron spin waves by irradiating electrons in the two-dimensional wire structure at or before the branching point with optical signals or is input electron spin waves output from an adjacent one-dimensional wire structure. The output section outputs an electron spin wave on which the electron spin wave propagated through the first branching wire. The electron spin wave propagated through the second branching wire and the electron spin wave propagated through the third branching wire at or after junction point are multiplexed. The distance between the spin wave generator and the output section is approximately an integer multiple of the half-wavelength of the electron spin wave. In the first branching wire, a first gate electrode section is positioned along the first gate electrode. In the second branching wire, a second gate electrode section is positioned along the second gate electrode. In the third branching wire, a third gate electrode section is positioned along the second gate electrode. The lengths of the first gate electrode, the second gate electrode and the third gate electrode are approximately odd multiples of the half-wavelength of the electron spin wave. The width of the one-dimensional wire structure is smaller than the half-wavelength of the electron spin wave. The electron spin wave before entering the first gate electrode section, the second gate electrode section and the third gate electrode section from the spin wave generator is in the iPSH state or the PSH state. The first gate electrode, the second gate electrode and the third gate electrode respectively can apply a first gate voltage that makes the electron spin wave into the PSH state and a second gate voltage that makes the electron spin wave into the iPSH state.

In a logic operation element according to one embodiment, the one-dimensional wire structure comprises a material that, upon irradiation of light having a predetermined polarization state, generates an electron spin wave having a phase corresponding to the polarization state. At the branching point, the one-dimensional wire structure branches to form four branching wires of a first branching wire, a second branching wire, a third branching wire and a fourth branching wire. At the junction point, three branching wires of the first branching wire, the second branching wire and the third branching wire merge to form a single one-dimensional wire structure. The fourth branching wire forms a one-dimensional wire structure that does not merge with other branching wires. The logic device further comprises a first logic operation element, a second logic operation element, a third logic operation element and a fourth logic operation element. The first logic operation element comprises part of the first branching wire and a first gate electrode along the part of the first branching wire. The second logic operation element comprises part of the second branching wire and a second gate electrode along the part of the second branching wire. The third logic operation element comprises part of the fourth branching wire and a third gate electrode along the part of the fourth branching wire. The fourth logic operation element comprises other part of the fourth branching wire and a fourth gate electrode along the other part of the fourth branching wire. The two-dimensional wire structure comprises a spin wave generator, a first output section and a second output section. The spin wave generator either generates electron spin waves by irradiating electrons in the two-dimensional wire structure at or before the branching point with optical signals or is input electron spin waves output from an adjacent one-dimensional wire structure. The first output section outputs an electron spin wave on which the electron spin wave propagated through the first branching wire, the electron spin wave propagated through the second branching wire and the electron spin wave propagated through the third branching wire at or after junction point are multiplexed. The second output section outputs an electron spin wave propagated through the fourth branching wire. The distance between the spin wave generator and the first output section, and the distance between the spin wave generator and the second output section are approximately an integer multiple of the half-wavelength of the electron spin wave. In the first branching wire, a first gate electrode section is positioned along the first gate electrode. In the second branching wire, a second gate electrode section is positioned along the second gate electrode. In the fourth branching wire, a third gate electrode section along the third gate electrode and a fourth gate electrode section along the fourth gate electrode are positioned in series. The lengths of the first gate electrode, the second gate electrode, the third gate electrode and the fourth gate electrode are approximately odd multiples of the half-wavelength of the electron spin wave. The width of the one-dimensional wire structure is smaller than the half-wavelength of the electron spin wave. The electron spin wave before entering the first gate electrode section, the second gate electrode section and the third gate electrode section from the spin wave generator is in the iPSH state or the PSH state. The first gate electrode, the second gate electrode, the third gate electrode and the fourth gate electrode respectively can apply a first gate voltage that makes the electron spin wave into the PSH state and a second gate voltage that makes the electron spin wave into the iPSH state.

In one embodiment, the one-dimensional wire structure comprises a material that, upon irradiation of light having a predetermined polarization state, generates an electron spin wave having a phase corresponding to the polarization state. The gate electrode can apply a first gate voltage and a second gate voltage. The first gate voltage makes the state in the one-dimensional wire structure to the state in which only the Rashba interaction is active as a spin-orbit interaction to the electrons. The second gate voltage makes the state in the one-dimensional wire structure to the state in which no interaction is active. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. The gate electrode is positioned between the spin wave generator and the output section along the one-dimensional wire structure. The distance between the spin wave generator and the output section is approximately an integer multiple of the wavelength of the electron spin wave. The length of the gate electrode is approximately an odd multiple of the half wavelength of the electron spin wave. The width of the one-dimensional wire structure is smaller than half the wavelength of the electron spin wave. The logic input is the phase state of the electron spin wave at the spin wave generator. The logic output is the phase state of the electron spin wave at the output section.

In one embodiment, the one-dimensional wire structure comprises a material that, upon irradiation of light having a predetermined polarization state, generates an electron spin wave having a phase corresponding to the polarization state. The one-dimensional wire structure comprises a spin wave generator and an output section. The spin wave generator either generates electron spin waves by irradiating electrons in the one-dimensional wire structure with optical signals or is input electron spin waves output from an adjacent one-dimensional wire structure. The output section outputs the electron spin wave that has propagated through the one-dimensional wire structure. In the one-dimensional wire structure, a gate electrode section along the gate electrode is positioned between the spin wave generator and the output section. The distance between the spin wave generator and the output section is approximately an integer multiple of the half wavelength of the electron spin wave. The length of the gate electrode is approximately an odd multiple of the half-wavelength of the electron spin wave. The width of the one-dimensional wire structure is smaller than the half-wavelength of the electron spin wave. The electron spin wave before entering the gate electrode section from the spin wave generator is in the state in which only the Rashba interaction is active as a spin-orbit interaction to the electrons. The gate electrode can apply a first gate voltage and a second gate voltage. The first gate voltage makes the state in the one-dimensional wire structure to the state in which only the Rashba interaction is active as a spin-orbit interaction to the electrons. The second gate voltage makes the state in the one-dimensional wire structure to the state in which no interaction is active.

Any combination of the above components, and any conversion of the expressions of the present disclosure between methods, devices, systems, recording media, computer programs, etc., is also valid as an aspect of the present disclosure.

### ADVANTAGEOUS EFFECTS OF INVENTION

According to the present disclosure, it is possible to realize a logic device that can perform logic operations and processes such as majority logic operations based on wave interference without restrictions by means of high and low voltage levels while maintaining the interference nature of the wave on the optical input signals.

### BRIEF DESCRIPTION OF DRAWINGS

[FIG. 1] Fig. 1 is a schematic diagram of a logic operation element according to the first embodiment.
[FIG. 2] Fig. 2 is a schematic diagram of a NOT logic device according to the second embodiment.
[FIG. 3] Fig. 3 is a schematic diagram showing electrons propagating through the NOT logic device of Fig. 2.
[FIG. 4] Fig. 4 is a graph showing the relationship between the width of the one-dimensional wire structure and the relaxation time of an electron spin.
[FIG. 5] Fig. 5 is a schematic diagram of a switchable NOT logic device according to the third embodiment.
[FIG. 6] Fig. 6 is a schematic diagram of an XOR logic device according to the fourth embodiment.
[FIG. 7] Fig. 7 is a schematic diagram of an AND logic device according to the fifth embodiment.
[FIG. 8] Fig. 8 is a schematic diagram of an OR logic device according to the sixth embodiment.
[FIG. 9] Fig. 9 is a schematic diagram of a half-adder according to the seventh embodiment.
[FIG. 10] Fig. 10 is a schematic diagram of a logic operation element according to the eighth embodiment.
[FIG. 11] Fig. 11 is a schematic diagram of a logic operation element according to the ninth embodiment.
[FIG. 12] Fig. 12 is a schematic diagram of a logic operation element according to the tenth embodiment.
[FIG. 13] Fig. 13 is a schematic diagram of a logic device according to the twelfth embodiment.
[FIG. 14] Fig. 14 is a schematic diagram of a logic device according to the thirteenth embodiment.
[FIG. 15] Fig. 15 is a schematic diagram of a logic device according to the fourteenth embodiment.

### DESCRIPTION OF EMBODIMENTS

The invention will be explained below with reference to the drawings based on suitable embodiments. The embodiments are examples rather than limitations of the invention. Not all features or combinations of features described in the embodiments are necessarily essential to the invention. Identity or equivalent components, parts, and processes shown in each drawing shall be given the same symbol, and duplicate explanations will be omitted where appropriate. The scale and shape of each part shown in each drawing are set for convenience in order to facilitate explanation, and should not be construed as limiting unless otherwise noted. When terms such as "first," "second," etc. are used in this specification or in the claims, unless otherwise mentioned, such terms do not indicate any order or degree of importance, but only to distinguish one configuration from another. In addition, in each drawing, some parts of the components that are not important to the description of the embodiment are omitted from the drawing.

Before describing the specific embodiments, the underlying findings are explained.

In a one-dimensional wire structure formed by semiconductor quantum wells, electron spin waves with a predetermined phase state can be generated by irradiating polarized light to electrons in the one-dimensional wire structure. The electron spin wave with a predetermined phase state can also be input from an adjacent one-dimensional wire structure. The generated or input electron spin wave propagates in the one-dimensional wire structure. The electron spin wave can take on the following states, depending on the type and magnitude of the spin-orbit interaction acting on it.

The PSH, i.e., Persistent Spin Helix, state is realized when the strength of the Rashba spin-orbit interaction, α, is equal to the strength of the Dresselhaus spin-orbit interaction, β, i.e., α = β. In this case, the direction of the effective magnetic field created by the spin-orbit interaction is constant regardless of the direction of electron motion. Therefore, the precession of the spins is not affected by the scattering of electrons, and the spin relaxation is suppressed. Specifically, when the crystallographic orientation in the quantization axis direction is the [0 0 1] axis, coherent spin rotation persists in the [1 -1 0] direction of the crystal, while spin relaxation is suppressed in the [1 1 0] direction perpendicular to the aforementioned direction of the crystal, in which the spin direction propagates without rotation. On the other hand, when the crystallographic orientation in the quantization axis direction is the [1 0 -1 0] axis, coherent spin rotation persists in the [0 0 0 1] direction of the crystal, while spin relaxation is suppressed in the [1 1 2 0] direction perpendicular to the aforementioned direction of the crystal, in which the spin direction propagates without rotation.

The iPSH, i.e., inverse Persistent Spin Helix, state is realized when the sign of the strength of the Rashba spin-orbit interaction flips and becomes equal to the strength of the Dresselhaus spin-orbit interaction, i.e., α = -β. In this iPSH state, the direction of the effective magnetic field changes by 90 degrees with respect to the PSH state, changing from a spin precession state to a non-spin precession state. Specifically, when the crystallographic orientation in the quantization axis direction is the [0 0 1] axis, the spin direction propagates without rotation in the [1 -1 0] direction of the crystal, and coherent rotation of the spins is persistent in the [1 1 0] direction perpendicular to the aforementioned direction of the crystal. On the other hand, when the crystallographic orientation in the quantization axis direction is the [1 0 -1 0] axis, the spin direction propagates without rotation in the [0 0 0 1] direction of the crystal, and coherent rotation of the spins is persistent in the [1 1 2 0] direction perpendicular to the aforementioned direction of the crystal.

Another characteristic state is a state in which only the Rashba spin-orbit interaction is active as a spin-orbit interaction, i.e., α is not 0 and β=0, and a state in which there is no spin-orbit interaction, i.e., α=0 and β=0, etc.

Here, the strength of the Dresselhaus spin-orbit interaction, β, is an intrinsic value determined by the material, while the strength of the Rashba spin-orbit interaction, α, is a value that varies with the carrier concentration. The carrier concentration can be controlled by the amount of impurities doped into the one-dimensional wire structure, or by providing a gate electrode on part of the one-dimensional wire structure and applying a voltage to the gate electrode. Thus, a gate electrode can be provided in part of the one-dimensional wire structure, and the α of the portion of the gate electrode can be different from the α of the portions other than along the gate electrode.

Using the above modulation of α by the application of the gate voltage, it is possible to rotate the phase of the electron spin wave in the one-dimensional wire structure except at the gate electrode and to stop the phase rotation of the electron spin wave at the gate electrode. The following are three aspects of this approach.

The first aspect is a one-dimensional wire structure in which the portion of the gate electrode is in the PSH state and the portions other than the gate electrode are in the iPSH state. In this case, with regard to a quantum well with a one-dimensional wire structure in which electrons propagate inside, the [1 1 0] direction or [0 0 0 1] direction of the crystal is taken as the long axis direction, i.e., x-axis direction, and the [1 -1 0] direction or [1 1 2 0] direction of the crystal is taken as the y-axis direction orthogonal to the x-axis direction. When the one-dimensional wire structure is in the PSH state, electrons propagate without rotating the spin direction. On the other hand, when the one-dimensional wire structure is in the iPSH state, electrons propagate while maintaining coherent spin rotation. By applying a gate voltage with α = β to the gate electrode, the iPSH state other than the portion of the gate electrode can be converted to the PSH state. This allows the rotation of the spin direction of the electrons propagating through the one-dimensional wire structure to be controlled.

The second aspect is a one-dimensional wire structure in which the portion of the gate electrode is in the iPSH state and the portions other than the gate electrode are in the PSH state. In this case, the [1 -1 0] direction or [1 1 2 0] direction of the crystal is taken as the long axis direction, i.e., x-axis direction, and the [1 1 0] direction or [0 0 0 1] direction of the crystal is taken as the y-axis direction orthogonal to the x-axis direction. When the one-dimensional wire structure is in the iPSH state, electrons propagate without rotating the spin direction. On the other hand, when the one-dimensional wire structure is in the PSH state, electrons propagate while maintaining coherent spin rotation. By applying a gate voltage with α = -β to the gate electrode, the PSH state other than the portion of the gate electrode can be converted to the iPSH state. In the case of the above two aspects, the distance is the distance projected in the x-direction.

The third aspect is the case in which β = 0. This is a one-dimensional wire structure in which only the Rashba spin-orbit interaction is active in the portions other than the gate electrode and there is no spin-orbit interaction in the portion of the gate electrode. In this case, the long axis, i.e., x-axis, can be defined independent of the crystallographic orientation, and y-axis should be orthogonal to the x-axis. When there is no spin-orbit interaction in the one-dimensional wire structure, electrons propagate without rotating the spin direction. On the other hand, when the one-dimensional wire structure is in a state in which only Rashba spin-orbit interaction is active, electrons propagate while maintaining coherent spin rotation. By applying a gate voltage with α = 0 to the gate electrode, the state in which only the Rashba spin-orbit interaction is active in the portions other than the gate electrode can be converted to a state in which there is no spin-orbit interaction. In this case, the distance is the distance on the xy-plane.

These aspects allow controlling the rotation of the spin direction of the electrons propagating in the one-dimensional wire structure. In particular, when the length of the gate electrode is half the wavelength of the electron spin wave, the phase can be shifted 180° by stopping the rotation for half a wavelength and can be used as a NOT logic device. In the following, embodiments are mainly described using the first aspect, however it can be applied to the second aspect as well by interchanging the PSH and iPSH states.

Such one-dimensional wire structures can be fabricated as follows, e.g., Non-Patent Literature 1. Specifically, in the example of Non-Patent Literature 1, the InAlAs/InGaAs/InAlAs quantum well structures are epitaxially grown on an InP substrate using metal organic chemical vapor deposition, MOCVD, method, and then one-dimensional wire structures in the [1 1 0] direction are fabricated by photolithography and etching. The films are stacked in the following order from the InP substrate.
200 nm In_{0.52}Al_{0.48}As
6nm In_{0.52}Al_{0.48}As (Si doped at 1.2 x 10¹⁸cm⁻³
6nm In_{0.52}Al_{0.48}As
7nm In_{0.52}Ga_{0.47}As Quantum well
6nm In_{0.52}Al_{0.48}As
6nm In_{0.52}Al_{0.48}As (Si doping at 3.2×10¹⁸cm⁻³)
10nm In_{0.52}Al_{0.48}As
Here gate insulating layer (5nm Al₂O₃/95nm HfO₂) and gate electrode (10nm Cr/100nm Au) are used.

For example, in the above one-dimensional wire structure, simulation results of the states from α = -2β to α = 2β are disclosed in Non-Patent Literature 1. The iPSH state, i.e., α = -β, the state with zero Rashba spin-orbit interaction, i.e., α = 0, and the PSH state, i.e., α = β, have carrier concentrations of 1.23, 1.38 and 1.54 (×10¹⁶m⁻²), respectively. The gate voltages that achieve these carrier concentrations are in the range of -0.5 to -1.0 V, for example.

The first through third embodiments described below are all logic operation element in which logic input and logic output are phase states of electron spin waves, and furthermore, the logic is switched by switching the gate voltage applied to the gate electrode, depending on the embodiment. The fourth through seventh embodiments are logic devices that are constituted by combining the logic operation elements described in the second and/or third embodiments.

### The first embodiment

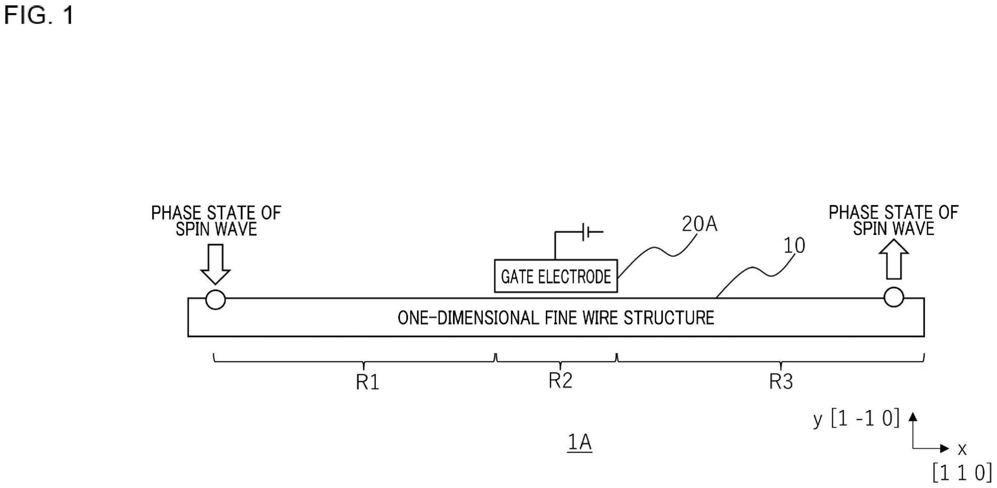

Figure 1 schematically shows a logic operation element 1A according to the first embodiment. The [1 1 0] direction of the crystal is taken in the long axis, i.e., x-axis, direction, and the [1 -1 0] direction is taken in the y-axis direction orthogonal to the x-axis, the same hereinafter. The logic operation element 1A comprises a one-dimensional wire structure 10 and a gate electrode 20A.

The one-dimensional wire structure 10 is set so that α = -β when no voltage is applied. The voltage applied to the gate electrode 20A takes a gate voltage value such that α = β. When the value of the applied voltage is close to this value, the electron spin wave in the one-dimensional wire structure 10 is converted from the iPSH state to the PSH state. On the other hand, when the value of applied voltage is a gate voltage value such that α = -β (or no voltage is applied), the iPSH state of the electrons in the one-dimensional wire structure 10 is maintained.

First, an electron with a specific phase state is input to the left end of the one-dimensional wire structure 10. The phase state at this time corresponds to the logic input. The electron spin wave of the input electron propagates through the one-dimensional wire structure 10 from left to right in the x direction, and then is extracted at the right end. The phase state at this time corresponds to the logic output.

Hereinafter in this specification, for simplicity, "the electron spin wave propagating in the region R is in the iPSH state" is expressed as "the region R is in the iPSH state" or the like. Assume that a gate voltage that causes a PSH state is applied to gate electrode 20A. In this case, since the region R1 and the region R3 of the one-dimensional wire structure 10 are not directly under the gate electrode 20A gate voltage is not applied to these regions. On the other hand, the region R2 is directly under the gate electrode 20A. Therefore the gate voltage is applied to this region. For example, when the region R1 was in the iPSH state, the region R2 is converted to the PSH state, and the region R3 returns to the iPSH state again. Electron spin waves propagating from left to right in the x direction through the one-dimensional wire structure 10 are extracted at the right end and their phase state is taken as the logic output.

Next, assume that a voltage is applied to gate electrode 20A that causes an iPSH state (or no voltage is applied). In this case, the gate voltage that causes the PSH state is not applied in any of the regions R1, R2 and R3 of the one-dimensional wire structure 10. In this case, the iPSH state is invariant in all regions, i.e., the region R1, the region R2 and the region R3. Electron spin waves propagating from left to right in the x direction through the one-dimensional wire structure 10 are extracted at the right end. The phase state at this time, generally different from when a gate voltage is applied to gate electrode 20A that causes a PSH state, is taken as the logic output.

Thus, according to this embodiment, by appropriately setting the length of the one-dimensional wire structure 10 and the gate electrode 20A, and by using the phase state of the electron spin wave before propagating through the one-dimensional wire structure 10 as the logic input, it is possible to configure a logic operation element that can output various logic outputs.

### The second embodiment

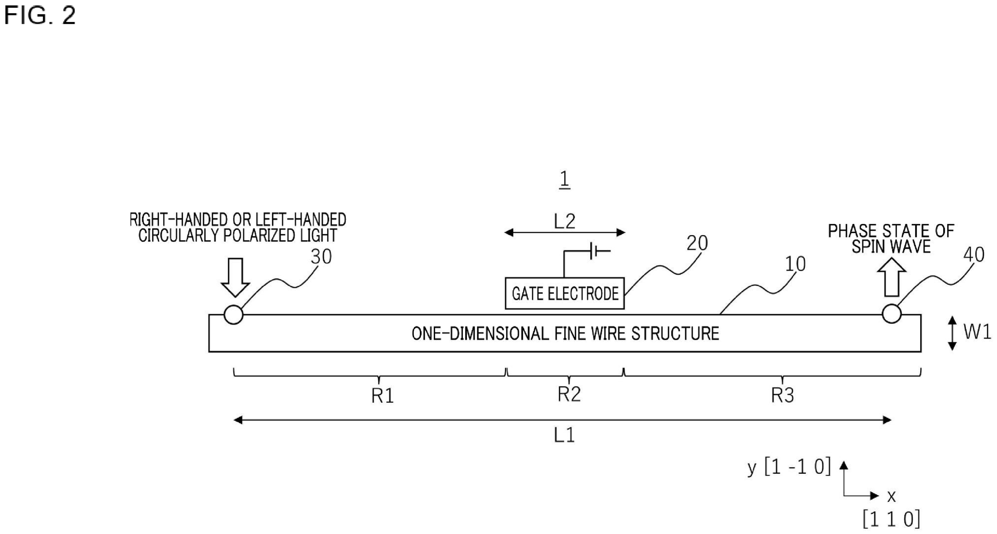

Figure 2 is a schematic diagram of a NOT logic device 1 according to the second embodiment. The NOT logic device 1 comprises a one-dimensional wire structure 10 and a gate electrode 20. The one-dimensional wire structure 10 comprises a spin wave generator 30 and an output section 40 that outputs the electron spin wave propagated through the one-dimensional wire structure 10. The spin wave generator 30 either generates electron spin waves by irradiating electrons with optical signals or is input electron spin waves output from an adjacent one-dimensional wire structure. In the latter case, the output section of the adjacent one-dimensional wire structure serves as the spin wave generator 30 of the one-dimensional wire structure 10. The gate electrode 20 is positioned between the spin wave generator 30 and the output section 40 along the one-dimensional wire structure 10.

The one-dimensional wire structure 10 comprises a material that, upon irradiation of light having a predetermined polarization state, generates electron spin waves having a phase depending on this polarization state. The spin wave generator 30 generates electron spin waves by irradiating electrons with optical signals. The output section 40 outputs the electron spin wave that has propagated through the one-dimensional wire structure 10. The phase state of the output electron spin wave can be detected, for example, by a magnetoresistive element (MR element) positioned near the output section 40.

For example, the polarization state of the irradiated light may be either right-handed circularly polarized or left-handed circularly polarized. When such light is irradiated to the spin wave generator 30, the spin wave generator 30 generates electron spin waves of phase 0 for right-handed circularly polarized light and electron spin waves of phase π for left-handed circularly polarized light. Hereafter, the electron spin wave of phase 0 is associated with the logic value "0" and the electron spin wave of phase π is associated with the logic value "1". Thus, in this case, the right-handed circular polarization of the irradiated light corresponds to the logic value 0, and the left-handed circular polarization corresponds to the logic value 1.

The gate electrode 20 converts the state of the electron in the one-dimensional wire structure from the iPSH state to the PSH state by applying a gate voltage that converts the state of the electron spin wave to PSH state to a portion of the one-dimensional wire structure 10. In the example shown in Figure 2, the distance L1 between the spin wave generator 30 and the output section 40 is approximately an integer multiple of the wavelength of the electron spin wave propagating in the one-dimensional wire structure 10. The region R1 and the region R3 of the one-dimensional wire structure 10 are not directly under the gate electrode 20, therefore no gate voltage is applied to these regions. On the other hand, the region R2 is directly under the gate electrode 20, therefore the gate voltage is applied to this region. For example, when the electron spin wave in the region R1 was in the iPSH state, it is converted to the PSH state in the region R2 and returns to the iPSH state again in the region R3.

The distance L1 between the spin wave generator 30 and the output 40 is approximately an integer multiple of the wavelength of the electron spin wave propagating in the one-dimensional wire structure 10. The length L2 of the gate electrode 20 is approximately an odd multiple of the half wavelength of the electron spin wave. The width W1 of the one-dimensional wire structure is smaller than the half wavelength of the electron spin wave.

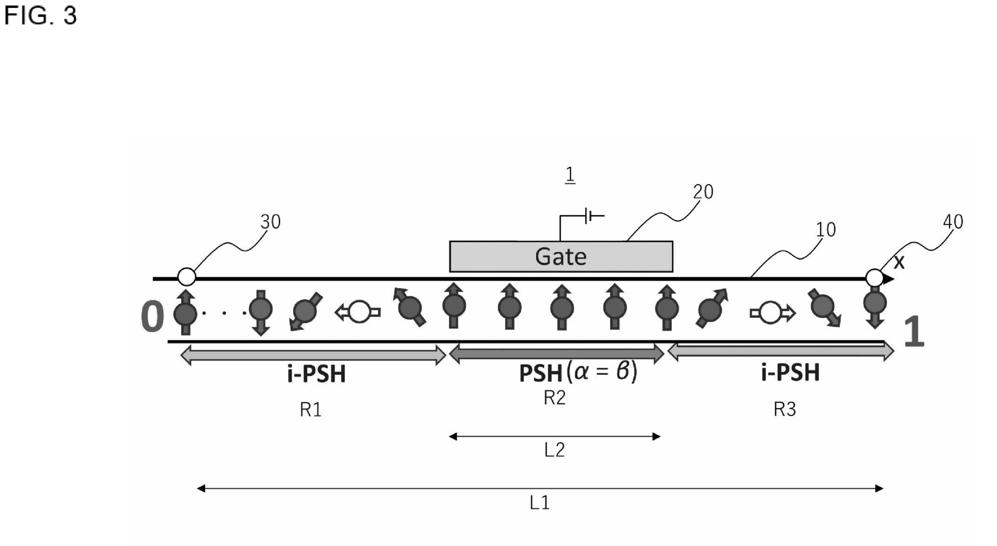

Figure 3 is a schematic diagram of electrons propagating through the NOT logic device 1 of Figure 2. First, the spin wave generator 30 is irradiated with right-handed circularly polarized light. The spin wave generator 30 generates an electron spin wave, upward, with phase 0. In the region R1, the electron spin wave of the one-dimensional wire structure 10 is in the iPSH state, i.e., α = -β. Thus, in the region R1, the electrons propagate while maintaining coherent spin rotation.

In the region R2, the one-dimensional wire structure 10 is in the PSH state, i.e., α = β, because it is directly under the gate electrode 20 which applies the gate voltage. Therefore, in the region R2, electrons propagate without rotating the spin direction. Since the length of the region R2, i.e., the length of gate electrode 20, is approximately an odd multiple of the half-wavelength of the electron spin wave, the phase of the electron spin wave is shifted by approximately π i.e., approximately half a wavelength, compared to the case in which no gate voltage is applied.

In the region R3, the one-dimensional wire structure 10 is in the iPSH state because it is not directly under the gate electrode 20 which applies the gate voltage. Therefore, in the region R3, electrons propagate while maintaining coherent spin rotation.

Since the distance between the spin wave generator 30 and the output section 40 is approximately an integer multiple of the wavelength of the electron spin wave and the phase of the electron spin wave is shifted by π in the region R2, the phase state of the electron spin wave output at the output section 40 is the opposite of the state at the spin wave generator 30, in other words, the phase is shifted by π. In other words, the electrons that were in a state corresponding to the logic value 0 at the spin wave generator 30 are in a state corresponding to the logic value 1 at the output section 40. Thus, when the logic value 0 is input to NOT logic device 1, the opposite logic value 1 is output.

Contrary to the above, consider the case in which the spin wave generator 30 is irradiated with left-handed circularly polarized light to generate an electron spin wave, downward, of phase π. In this case, the electrons that were in a state corresponding to the logic value 1 at the spin wave generator 30 are in a state corresponding to the logic value 0 at the output section 40. Therefore, when the logic value 1 is input to the NOT logic device 1, the opposite logic value 0 is output.

As explained above, NOT logic device 1 realizes a NOT circuit, also called a NOT gate or inverter, which realizes NOT logic without losing the nature of the wave.

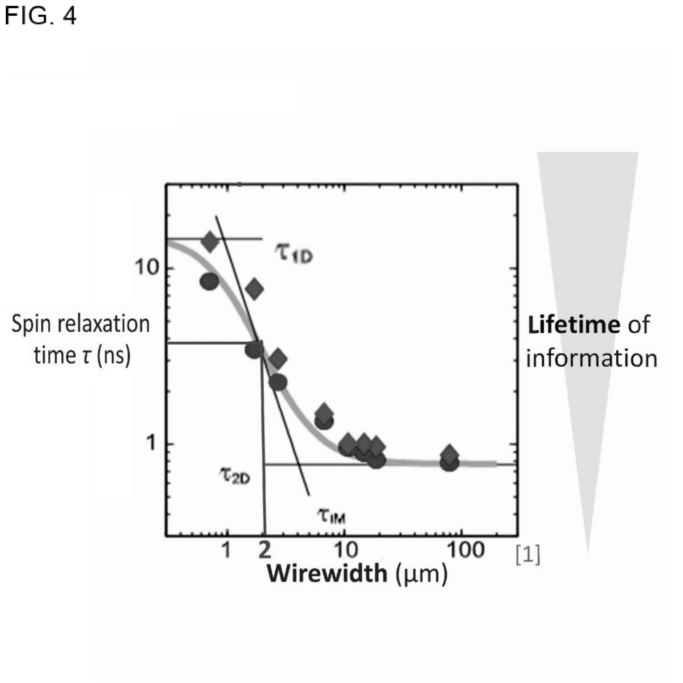

Figure 4 is a graph showing the relationship between the width of the one-dimensional wire structure and the relaxation time of the electron spin wave. The square dots in Figure 4 represent the case in which the crystallographic orientation is [1 1 0], and the round dots represent the case in which the crystallographic orientation is [1 -1 0]. In the above example, the wavelength of the electron spin wave is about 8 µm. As can be seen from Figure 4, by making the width of the one-dimensional wire structure half the wavelength or less, the time until the spin-polarized state relaxes can be kept 1 ns or more.

As explained above, according to this embodiment, it is possible to realize a logic device that can perform NOT logic operation on optical input signals while maintaining the interference nature of the wave.

### The third embodiment

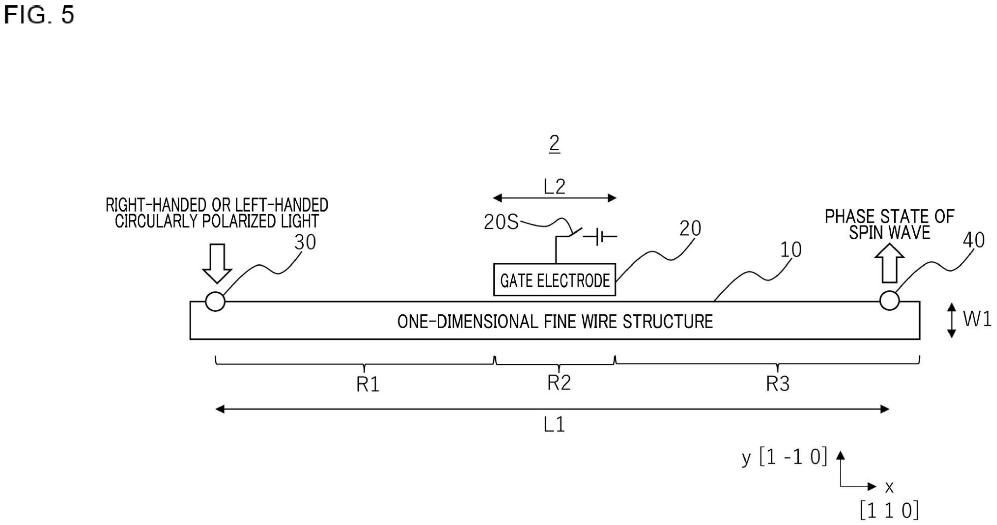

Figure 5 is a schematic diagram of the switchable NOT logic device 2 according to the third embodiment. The switchable NOT logic device 2 comprises a one-dimensional wire structure 10 and a gate electrode 20. The one-dimensional wire structure 10 comprises a spin wave generator 30 and an output section 40. The gate electrode 20 of the switchable NOT logic device 2 comprises a switch 20S that switches the applied gate voltage between a first gate voltage that makes the electron spin wave into the PSH state and a second gate voltage that makes the electron spin wave into the iPSH state. The other configuration of the switchable NOT logic device 2 is common to the configuration of the NOT logic device 1 in Figure 2.

When the switch 20S is at the first gate voltage, hereinafter also referred to as "switch 20S is ON" (the same applies when "20S" is another sign), the switchable NOT logic device 2 is substantially the same as the NOT logic device 1. Therefore, the switchable NOT logic device 2 functions as a logic device that can perform NOT logic operation on optical input signals while maintaining the interference nature of the wave.

On the other hand, when the switch 20S is at the second gate voltage, hereinafter also referred to as "switch 20S is OFF" (the same applies when "20S" is another sign), the switchable NOT logic device 2 outputs the same logic value from the output section 40 as the logic value at the spin wave generator 30. Thus, in this case, the switchable NOT logic device 2 functions as a buffer. Such a logic device that can switch between a buffer logic device and a NOT logic device is referred to herein as a "switchable NOT logic device."

As explained above, according to this embodiment, it is possible to realize a logic device that can selectively perform NOT logic operation or identity logic operation on optical input signals using the voltage level high or low while maintaining the interference nature of the wave.

### The fourth embodiment

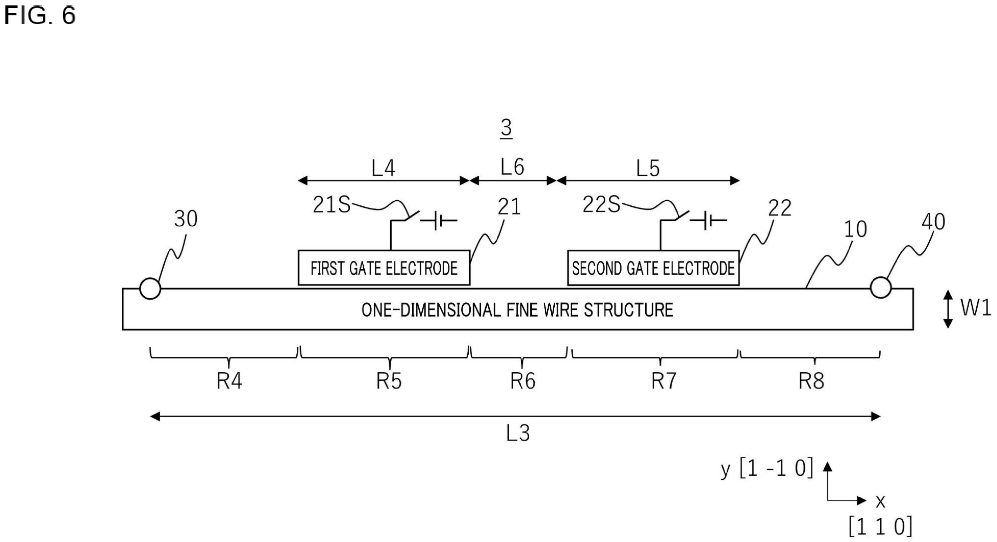

Figure 6 shows a schematic diagram of XOR logic device 3 according to the fourth embodiment. The XOR logic device 3 comprises a one-dimensional wire structure 10 and a first gate electrode 21 and a second gate electrode 22. The one-dimensional wire structure 10 comprises a material that generates electron spin waves with a phase corresponding to the polarization state upon irradiation of light having a predetermined polarization state. The first gate electrode 21 and the second gate electrode 22 can apply a first gate voltage that makes the electron spin waves into the PSH state or a second gate voltage that makes the electron spin waves into the iPSH state to a portion of the one-dimensional wire structure 10. The one-dimensional wire structure 10 comprises a spin wave generator 30 and an output section 40 that outputs the electron spin wave propagated through the one-dimensional wire structure 10. The spin wave generator 30 either generates electron spin waves by irradiating electrons in the one-dimensional wire structure 10 with optical signals or is input electron spin waves output from an adjacent one-dimensional wire structure. The distance L3 between the spin wave generator 30 and the output section 40 is approximately an integer multiple of the wavelength of the electron spin wave. The length L4 of the first gate electrode 21 and the length L5 of the second gate electrode 22 are each approximately odd multiples of the half-wavelength of the electron spin wave. The width W1 of the one-dimensional wire structure 10 is smaller than the half-wavelength of the electron spin wave. The first gate electrode 21 and the second gate electrode 22 have a switch 21S and a switch 22S, respectively, that switch the applied gate voltage between the first gate voltage and the second gate voltage. The first gate electrode 21 and the second gate electrode 22 are arranged in series along the one-dimensional wire structure 10.

The region R4, the region R6 and the region R8 are in the iPSH state. The region R5 is in the PSH state when the switch 21S is ON and in the iPSH state when the switch 21S is OFF. The region R7 is in the PSH state when the switch 22S is ON and in the iPSH state when the switch 22S is OFF.

Consider the following case in which the spin wave generator 30 is irradiated with right-handed circularly polarized light to generate an electron spin wave, upward, with phase 0. The phase state of the electron spin wave output from the output section 40 is described according to the ON/OFF of the switch 21S and the switch 22S.

### (In case of the switch 21S = OFF and the switch 22S = OFF)

In the region R4, the electron propagates while maintaining coherent spin rotation.

In the region R5, the electron propagates while maintaining coherent spin rotation.

In the region R6, the electron propagates while maintaining coherent spin rotation.

In the region R7, the electron propagates while maintaining coherent spin rotation.

In the region R8, the electron propagates while maintaining coherent spin rotation.

Since the distance L3 is approximately an integer multiple of the wavelength of the electron spin wave, the phase state of the electron spin wave output from the output section 40 is approximately the same as that at the spin wave generator 30, i.e., the phase difference between the spin wave generator 30 and the output section 40 is approximately an integer multiple of 2π. Therefore, the output section 40 outputs an electron spin wave, upward, with phase 0.

### (In case of the switch 21S = OFF and the switch 22S = ON)

In the region R4, the electron propagates while maintaining coherent spin rotation.

In the region R5, the electron propagates while maintaining coherent spin rotation.

In the region R6, the electron propagates while maintaining coherent spin rotation.

In the region R7, the electrons propagate without rotating the spin direction.

Since the length of the region R7, i.e., the length of the second gate electrode 22, is approximately an odd multiple of the half-wavelength of the electron spin wave, the phase of the electron spin wave is shifted by approximately an odd multiple of π, i.e., approximately a half-wavelength.

In the region R8, the electron propagates while maintaining coherent spin rotation.

Since the distance L3 is approximately an integer multiple of the electron spin wave wavelength and the phase of the electron spin wave is shifted by approximately π in the region R7, the phase state of the electron spin wave output from output section 40 is approximately the opposite of the state at the spin wave generator 30, i.e., the phase difference between the spin wave generator 30 and the output section 40 is approximately an odd multiple of π. Thus, the output section 40 outputs an electron spin wave, downward, with phase π.

### (In case of the switch 21S = ON and the switch 22S = OFF)

In the region R4, the electron propagates while maintaining coherent spin rotation.

In the region R5, the electrons propagate without rotating the spin direction.

Since the length of the region R5, i.e., the length of the first gate electrode 21, is approximately an odd multiple of the half-wavelength of the electron spin wave, the phase of the electron spin wave is shifted by approximately an odd multiple of π, i.e., approximately a half-wavelength.

In the region R6, the electron propagates while maintaining coherent spin rotation.

In the region R7, the electron propagates while maintaining coherent spin rotation.

In the region R8, the electron propagates while maintaining coherent spin rotation.

Since the distance L3 is approximately an integer multiple of the wavelength of the electron spin wave and the phase of the electron spin wave is shifted by approximately π in the region R5, the phase state of the electron spin wave output from output section 40 is approximately the opposite of the state at the spin wave generator 30, i.e., the phase difference between the spin wave generator 30 and the output section 40 is approximately an odd multiple of π. Thus, the output section 40 outputs an electron spin wave, downward, with phase π.

### (In case of the switch 21S = ON and the switch 22S = ON)

In the region R4, the electron propagates while maintaining coherent spin rotation.

In the region R5, the electrons propagate without rotating the spin direction.

Since the length of the region R5, i.e., the length of the first gate electrode 21, is approximately an odd multiple of the half-wavelength of the electron spin wave, the phase of the electron spin wave is shifted by approximately an odd multiple of π, i.e., approximately a half-wavelength.

In the region R6, the electron propagates while maintaining coherent spin rotation.

In the region R7, the electron propagates without rotating the spin direction.

Since the length of the region R7, i.e., the length of the second gate electrode 22, is approximately an odd multiple of the half-wavelength of the electron spin wave, the phase of the electron spin wave is shifted by approximately an odd multiple of π, i.e., approximately a half-wavelength.

In the region R8, the electron propagates while maintaining coherent spin rotation.

Since the distance L3 is approximately an integer multiple of the electron spin wave wavelength and the phase of the electron spin wave is shifted by approximately π in the region R5 and the region R7, both the region R5 and the region R7 together are shifted by approximately 2π, the phase state of the electron spin wave output from the output section 40 is approximately the same as that at the spin wave generator section 30, i.e., the phase difference between the spin wave generator 30 and the output section 40 is approximately an integer multiple of 2π. Therefore, the output section 40 outputs an electron spin wave, upward, with phase 0.

### Now assume the following.

The state in which the switch 21S is ON corresponds to the logic value of the first input variable = 1,
the state in which the switch 21S is OFF corresponds to the logic value of the first input variable = 0,
the state in which the switch 22S is ON corresponds to the logic value of the second input variable = 1,
the state in which the switch 22S is OFF corresponds to the logic value of the second input variable = 0,
a proposition is "true", i.e., the logical value = 1, when the state at the spin wave generator 30 and the phase state of the electron spin wave output from the output section 40 are opposite and
a proposition is "false", i.e., the logical value = 0, when the state at the spin wave generator 30 and the phase state of the electron spin wave output from the output section 40 are the same.

Then, the truth table is shown in Table 1.

### Table 1

**[Table 1]**

| FIRST VARIABLE / SWITCH 21S | SECOND VARIABLE / SWITCH 22S | TRUTH VALUE |
|---|---|---|
| 0 /OFF | 0 /OFF | 0 |
| 0 /OFF | 1/ON | 1 |
| 1/ON | 0 /OFF | 1 |
| 1/ON | 1/ON | 0 |

Thus, by making the ON/OFF state of each of the switch 21S and the switch 22S correspond to 1/0 of the first variable and the second variable, an XOR circuit, also called an XOR gate, which realizes XOR logic can be realized. In other words, according to this embodiment, it is possible to realize a logic device that enables XOR logic operation to be performed on optical input signals using high and low voltage levels while maintaining the interference nature of the wave.

### The fifth embodiment

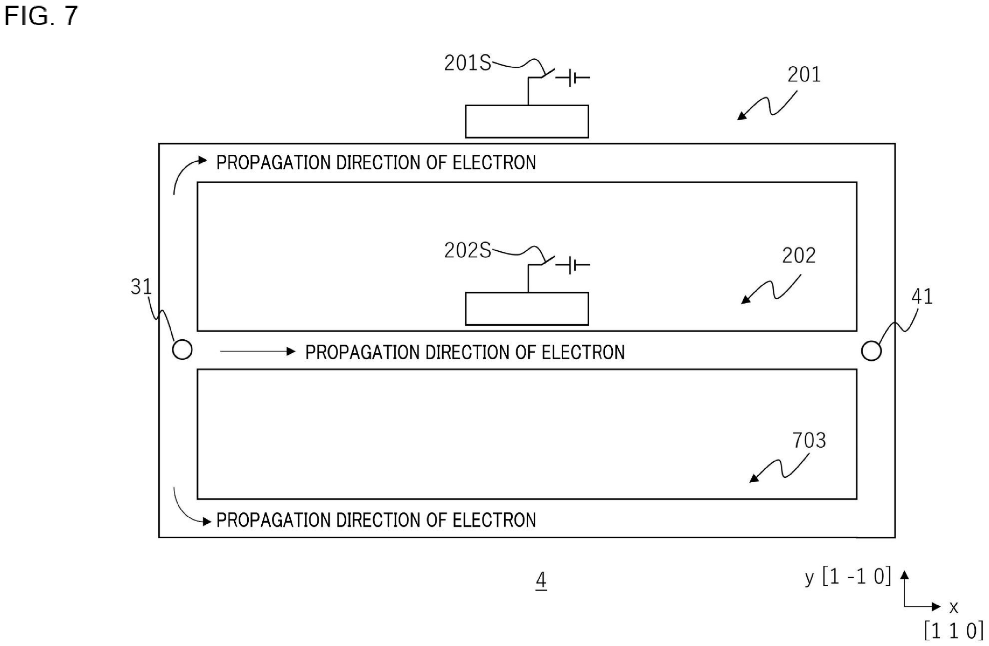

Figure 7 is a schematic diagram of an AND logic device 4 according to the fifth embodiment. The AND logic device 4 comprises a first switchable NOT logic device 201, a second switchable NOT logic device 202 and a third one-dimensional wire structure 703 connected in parallel. The first switchable NOT logic device 201 and the second switchable NOT logic device 202 are the switchable NOT logic devices described in the third embodiment. The spin wave generator 31 of the first switchable NOT logic device 201, the spin wave generator 31 of the second switchable NOT logic device 202 and the spin wave generator 31 of the third one-dimensional wire structure 703 are common. The output section 41 of the first switchable NOT logic device 201, the output section 41 of the second switchable NOT logic device 202 and the output section 41 of the third one-dimensional wire structure 703 are common.

The electron spin waves generated by the spin wave generator 32 branch into equal amounts in the three directions and propagate in the x direction through the first switchable NOT logic device 201, the second switchable NOT logic device 202 and the third one-dimensional wire structure 703, respectively. Here in the three directions, the distances from the spin wave generator 31 to the output section 41 are equal in projection in the x direction. The electron spin waves propagating through the first switchable NOT logic device 201, the second switchable NOT logic device 202 and the third one-dimensional wire structure 703 are combined at the output section 41 to perform majority logic.

As in the fourth embodiment, the spin wave generator 31 is irradiated with right-handed circularly polarized light to generate an electron spin wave, upward, with phase 0. The output results according to the ON/OFF of the switch 201S and the switch 202S are shown in Table 2. The electron spin waves propagated through the first switchable NOT logic device 201, the second switchable NOT logic device 202 and the third one-dimensional wire structure 703 are combined at the output section 41 and the output is determined by majority logic. As in the fourth embodiment, it is assumed that a proposition is "true" (the logic value = 1) when the state at the spin wave generator 31 and the phase state of the electron spin wave output from the output section 41 are opposite, and that a proposition is "false" (the logic value = 0) when the state in the spin wave generator 31 and the phase state of the electron spin wave output from the output section 41 are the same.

### Table 2.

**[Table 2]**

| FIRST VARIABLE / SWITCH 201S | SECOND VARIABLE / SWITCH 202S | THIRD ONE-DIMENSIONAL FINE WIRE STRUCTURE 703 | TRUTH VALUE (MAJORITY VALUE) |
|---|---|---|---|
| 0/OFF | 0/OFF | 0 | 0 |
| 0/OFF | 1/ON | 0 | 0 |
| 1/ON | 0/OFF | 0 | 0 |
| 1/ON | 1/ON | 0 | 1 |

Thus, by making the ON/OFF state of each of the switch 201S and the switch 202S correspond to 1/0 of the first variable and the second variable, an AND circuit, also called an AND gate, which realizes AND logic can be realized. In other words, according to this embodiment, it is possible to realize a logic device that can perform AND operation on optical input signals using high and low voltage levels while maintaining the interference nature of the wave.

### The sixth embodiment

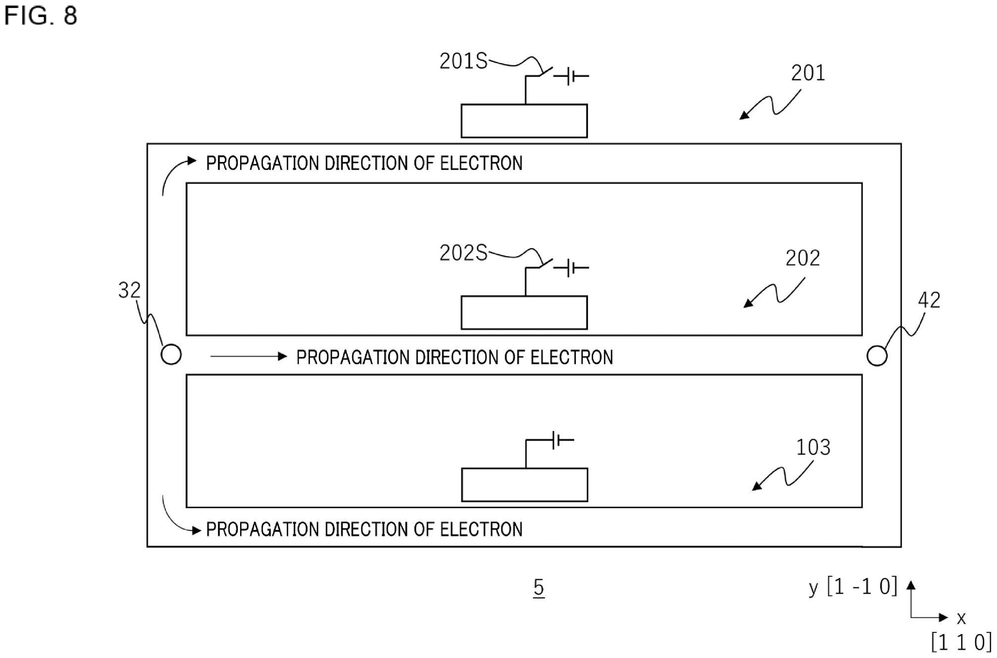

Figure 8 is a schematic diagram of an OR logic device 5 according to the sixth embodiment. The OR logic device 5 comprises a first switchable NOT logic device 201, a second switchable NOT logic device 202 and a third NOT logic device 103 connected in parallel. The first switchable NOT logic device 201 and the second switchable NOT logic device 202 are the switchable NOT logic devices described in the third embodiment. The third NOT logic device 103 is the NOT logic device described in the second embodiment. The spin wave generator 31 of the first switchable NOT logic device 201, the spin wave generator 31 of the second switchable NOT logic device 202 and the spin wave generator 31 of the third NOT logic device 103 are common. The output section 42 of the first switchable NOT logic device 201, the output section 42 of the second switchable NOT logic device 202 and the output section 42 of the third NOT logic device 103 are common.

The electron spin waves generated by the spin wave generator 32 branch into equal amounts in the three directions and propagate in the x direction through the first switchable NOT logic device 201, the second switchable NOT logic device 202 and the third NOT logic device 103, respectively. Here in the three directions, the distance from the spin wave generator 32 to the output 42 is equal in projection in the x direction. The electron spin waves propagating through the first switchable NOT logic device 201, the second switchable NOT logic device 202 and the third NOT logic device 103 are combined at the output section 42 to perform majority logic.

As in the fifth embodiment, the spin wave generator 32 is irradiated with right-handed circularly polarized light to generate an electron spin wave, upward, with phase 0. The output results according to the ON/OFF of the switch 201S and the switch 202S are shown in Table 3. The electron spin waves propagated through the first switchable NOT logic device 201, the second switchable NOT logic device 202 and the third NOT logic device 103 are combined at the output section 42 and the output is determined by majority logic. As in the fifth embodiment, it is assumed that a proposition is "true" (the logic value = 1) when the state at the spin wave generator 32 and the phase state of the electron spin wave output from the output section 42 are opposite and that a proposition is "false" (the logic value = 0) when the state at the spin wave generator 32 and the phase state of the electron spin wave output from the output section 42 are the same.

### Table 3.

**[Table 3]**

| FIRST VARIABLE / SWITCH 201S | SECOND VARIABLE / SWITCH 202S | THIRD NOT LOGIC DEVICE 103 | TRUTH VALUE (MAJORITY VALUE) |
|---|---|---|---|
| 0/OFF | 0/OFF | 1 | 0 |
| 0/OFF | 1/ON | 1 | 1 |
| 1/ON | 0/OFF | 1 | 1 |
| 1/ON | 1/ON | 1 | 1 |

Thus, by making the ON/OFF state of each of the switch 201S and the switch 202S correspond to 1/0 of the first variable and the second variable, an OR circuit, also called an OR gate, which realizes OR logic can be realized. In other words, according to this embodiment, it is possible to realize a logic device that can perform OR operations on optical input signals using high and low voltage levels while maintaining the interference nature of the wave.

### The seventh embodiment

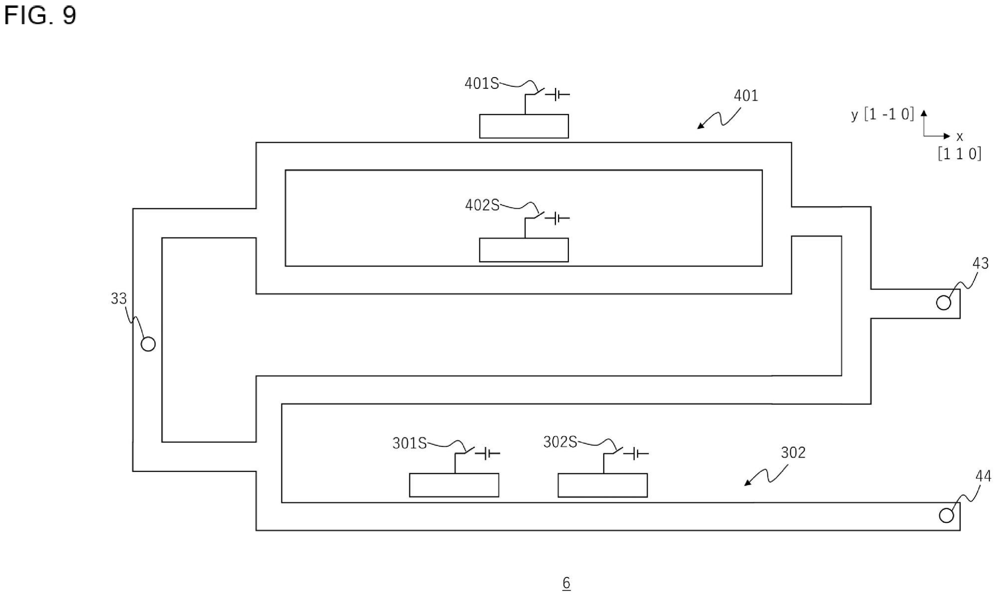

Figure 9 is a schematic diagram of a half-adder 6 according to the seventh embodiment. This half-adder 6 comprises a first AND logic device 401 and a second XOR logic device 302 connected in parallel. The first AND logic device 401 is the AND logic device described in the fifth embodiment. The second XOR logic device 302 is the XOR logic device described in the fourth embodiment. The phase state of the electron spin wave output from the output section 43 of the first AND logic device 401 represents the upper bit of a 2-bit binary number, and the phase state of the electron spin wave output from the output section 44 of the second XOR logic device represents the lower bit of a 2-bit binary number.

As in the fifth embodiment, the spin wave generator 33 is irradiated with right-handed circularly polarized light to generate an electron spin wave, upward, with phase 0. The output results according to the ON/OFF of the switches 401S and 301S and the switches 402S and 302S are shown in Table 4, the same logical value as the switch 301S is input to the switch 401S and the same logical value as the switch 302S is input to switch 402S. As in the fifth embodiment, it is assumed that a proposition is "true" (the logical value = 1) when the state at the spin wave generator 33 and the phase state of the electron spin wave output from the output section 43 and the output section 44 are opposite, and a proposition is " False" (the logical value = 0) when the state at the spin wave generator 33 and the phase state of the electron spin wave output from the output section 43 and the output section 44 are the same.

### Table 4.

**[Table 4]**

| FIRST VARIABLE / SWITCH 401S, 301S | SECOND VARIABLE / SWITCH 402S, 302S | OUTPUT SECTION OF FIRST AND LOGIC DEVICE/UPPER BIT OF 2-BIT BINARY NUMBER | OUTPUT SECTION OF SECOND AND LOGIC DEVICE/LOWER BIT OF 2-BIT BINARY NUMBER |
|---|---|---|---|
| 0/OFF | 0/OFF | 0 | 0 |
| 0/OFF | 1/ON | 0 | 1 |
| 1/ON | 0/OFF | 0 | 1 |
| 1/ON | 1/ON | 1 | 0 |

The output section 43 of the first AND logic device 401 outputs the upper bit of the binary sum of the first variable corresponding to the ON/OFF state of the switch 401S and the switch 301S and the second variable corresponding to the ON/OFF state of the switch 402S and the switch 302S. The output section 44 of the second XOR logic device 302 outputs the lower bit of the binary sum of the first variable corresponding to the ON/OFF state of the switch 401S and the switch 301S and the second variable corresponding to the ON/OFF state of the switch 402S and the switch 302S. In other words, according to this embodiment, a half-adder can be realized for optical input signals while maintaining the interference nature of the wave.

The following embodiments, eighth embodiment through the thirteenth embodiment, all have the logic input as a high or low of the gate voltage and the logic output as the phase of the electron spin wave.

### The eighth embodiment

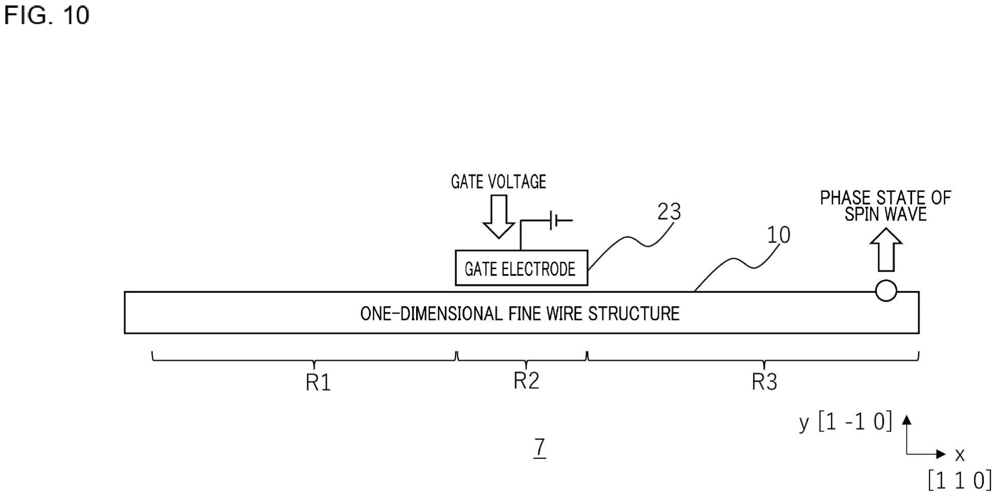

Figure 10 is a schematic diagram of a logic operation element 7 according to the eighth embodiment. The logic operation element 7 comprises a one-dimensional wire structure 10 through which electron spin waves propagate, and a gate electrode 23 along the one-dimensional wire structure 10. The [1 1 0] direction of the crystal is taken in the long axis, i.e., x-axis, direction, and the [1 -1 0] direction is taken in the y-axis direction orthogonal to the x-axis, the same hereinafter. Electron spin waves propagating in the one-dimensional wire structure are in the iPSH state.

The voltage applied to the gate electrode 23 is either a first gate voltage that makes the electron spin wave into the PSH state or a second gate voltage that makes the electron spin wave into the iPSH state. In the latter case, the iPSH state of the electron spin wave in the one-dimensional wire structure 10 is maintained.

The electron spin wave propagates from left to right in the x direction through the one-dimensional wire structure 10 and is then extracted at the right end. The phase state at this point corresponds to the logic output.

Assume that the first gate voltage is applied to the gate electrode 23. In this case, since the region R1 and the region R3 of the one-dimensional wire structure 10 are not directly under the gate electrode 23, no gate voltage is applied to the region R1 and the region R3. On the other hand, the region R2 is directly under the gate electrode 23, therefore the first gate voltage is applied to the region R2. For example, when the region R1 was in the iPSH state, the region R2 is converted to the PSH state, and the region R3 returns to the iPSH state again. Electron spin waves propagating from left to right in the x direction through the one-dimensional wire structure 10 are extracted at the right end and their phase state is taken as the logic output.

Next, assume that a second gate voltage is applied to the gate electrode 23. In this case, the first gate voltage is not applied in any of the regions R1, R2 and R3 of the one-dimensional wire structure 10. In this case, the iPSH state is invariant in all regions R1, R2 and R3. Electron spin waves propagating from left to right in the x direction through the one-dimensional wire structure 10 are extracted at the right end. The phase state at this time, generally different from the case when the first gate voltage is applied to the gate electrode 23, is the logic output.

Thus, according to this embodiment, by appropriately setting the length of the one-dimensional wire structure 10 and the gate electrode 23, and by using the high/low voltage applied to the gate electrode 23, i.e., whether it is the first gate voltage or the second gate voltage, as the logic input, it is possible to realize a logic operation element that can output various logic outputs while maintaining the interference nature of the wave.

### The ninth embodiment

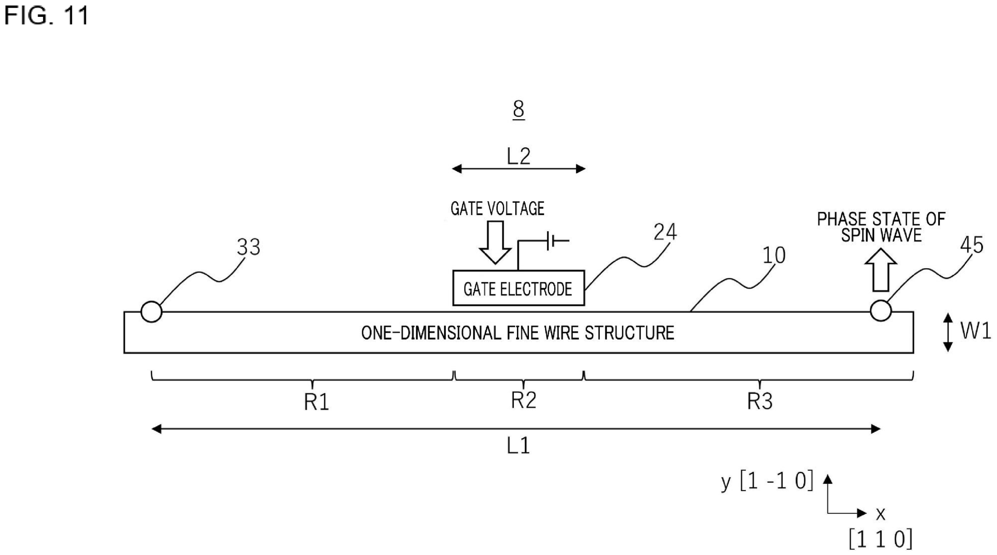

Figure 11 is a schematic diagram of a logic operation element 8 with one logic input according to the ninth embodiment. The logic operation element 8 comprises a one-dimensional wire structure 10 and a gate electrode 24. The one-dimensional wire structure 10 comprises a spin wave generator 33 and an output section 45.

The one-dimensional wire structure 10 comprises a material that, upon irradiation of light having a predetermined polarization state, generates electron spin waves having a phase depending on this polarization state. The spin wave generator 33 either generates electron spin waves by irradiating the electrons in the one-dimensional wire structure 10 with optical signals, or the spin wave generator 33 is input the electron spin waves output from the adjacent one-dimensional wire structure. The output section 45 outputs the electron spin wave that has propagated through the one-dimensional wire structure 10.

The gate electrode 24 applies a first gate voltage that makes the electron spin wave into the PSH state or a second gate voltage that makes the electron spin wave into the iPSH state to part of one-dimensional wire structure 10, thereby changing the state of the electron spin wave in the one-dimensional wire structure between the PSH state and the iPSH state or the state of the electron spin wave is maintained. In the example of Figure 11, the distance L1 between the spin wave generator 33 and the output section 45 is approximately an integer multiple of the half-wavelength of the electron spin wave propagating in the one-dimensional wire structure 10. The region R1 and the region R3 of the one-dimensional wire structure 10 are not directly under the gate electrode 24, therefore no gate voltage is applied to these regions. On the other hand, the region R2 is directly under the gate electrode 24, therefore the gate voltage is applied to this region. When the second gate voltage is applied, if the region R1 was in the iPSH state, the region R2 is converted to the PSH state and the region R3 returns to the iPSH state again.

The high and low voltage applied to the gate electrode 24 is used as the logic input. In other words, the voltage applied to the gate electrode 24 corresponds to the input logic value "1" when the voltage is the first gate voltage, and the voltage applied to the gate electrode 24 corresponds to the input logic value "0" when the voltage is the second gate voltage, the same applies hereinafter.

With respect to the phase state of the electron spin wave extracted at the output section 45, the electron spin wave with phase 0 corresponds to the output logic value "0" and the electron spin wave with phase π corresponds to the output logic value "1", respectively. Thus, in this case, the right-handed circular polarization of the irradiated light corresponds to the logic value 0, and the left-handed circular polarization corresponds to the logic value 1.

The distance L1 between the spin wave generator 33 and the output section 45 is approximately an integer multiple of the half wavelength of the electron spin wave propagating in the one-dimensional wire structure 10. The length L2 of the gate electrode 24 is approximately an odd multiple of the half-wavelength of the electron spin wave. The width W1 of the one-dimensional wire structure is smaller than the half-wavelength of the electron spin wave.

When the input logic value of the gate voltage is 0 with respect to phase 0 of the input electron spin wave, the electron spin wave propagates in the iPSH state. The logic operation element 8 operates differently depending on whether the distance L1 between the spin wave generator 33 and the output 45 is an even multiple of a half wavelength, in other words, an integer multiple of the wavelength, or an odd multiple of a half wavelength, in other words, a half-integer multiple of the wavelength. When L1 is an even multiple of the half wavelength, i.e., L1 = nλ, in which n is a natural number and λ is the wavelength (the same below), the phase state of the electron spin wave at the output section 45 is 0, therefore the logic operation element 8 is an element that performs an identity logic operation. On the other hand, when L1 is an odd multiple of half wavelength, i.e., L1=(n+1/2)λ, the phase state of the electron spin wave at the output section 45 is π, therefore the logic operation element 8 is an element that performs a NOT logic operation.

Next, when the input logic value of the gate voltage is 1 with respect to the phase 0 of the input electron spin wave, the phase of the electron spin wave does not change during (1/2)λ, when the electron spin wave is converted from the iPSH state to the PSH state. Therefore, when L1 is an even multiple of half wavelength, i.e., L1 = nλ, the phase state of the electron spin wave in the output section 45 becomes π, and the logic operation element 8 becomes an element that performs a NOT logic operation. On the other hand, when L1 is an odd multiple of the half wavelength, i.e., L1=(n+1/2)λ, the phase state of the electron spin wave at the output section 45 becomes 0, and the logic operation element 8 becomes an element that performs a identity logic operation.

Thus, according to this embodiment, it is possible to realize an identity logic operation element with one logic input and a NOT logic operation element with one logic input while maintaining the interference nature of the wave.

### The tenth embodiment

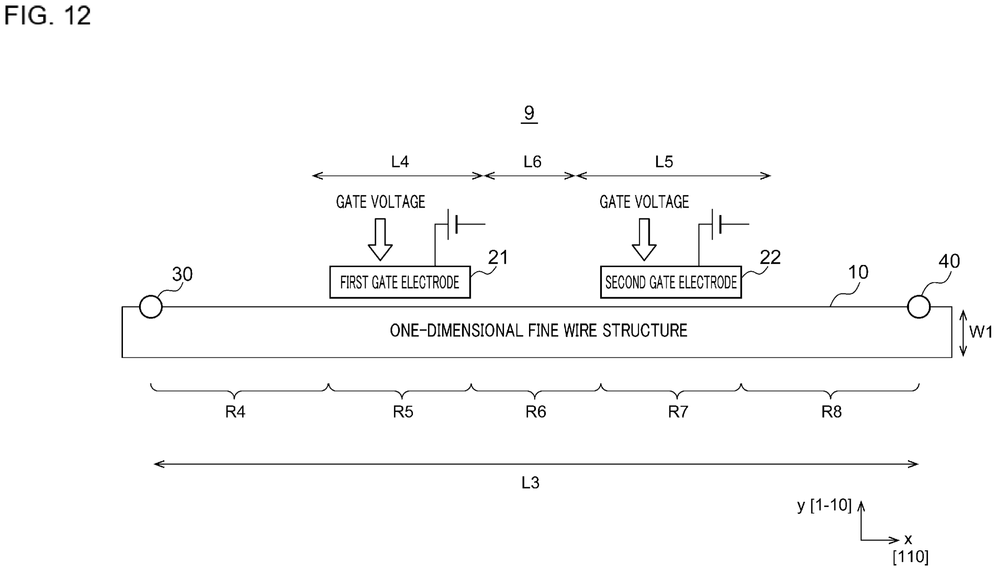

Figure 12 is a schematic diagram of a logic operation element 9 with two logic inputs according to the tenth embodiment. The logic operation element 9 comprises a one-dimensional wire structure 10, a first gate electrode 21 and a second gate electrode 22. The one-dimensional wire structure 10 comprises a material that, upon irradiation of light having a predetermined polarization state, generates electron spin waves having a phase corresponding to this polarization state. The first gate electrode 21 and the second gate electrode 22 apply a first gate voltage that makes the electron spin wave into the PSH state or a second gate voltage that makes the electron spin wave into the iPSH state to part of one-dimensional wire structure 10, thereby changing the state of the electron spin wave in the one-dimensional wire structure between the PSH state and the iPSH state or the state of the electron spin wave is maintained. The one-dimensional wire structure 10 comprises a spin wave generator 30 and an output section 40. The spin wave generator 30 either generates electron spin waves by irradiating the electrons with optical signals, or the spin wave generator 30 is input the electron spin waves output from the adjacent one-dimensional wire structure. The output section 40 outputs the electron spin wave that has propagated through the one-dimensional wire structure 10. The distance L3 between the spin wave generator 30 and the output section 40 is approximately an integer multiple of the half wavelength of the electron spin wave. The length L4 of the first gate electrode 21 and the length L5 of the second gate electrode 22 are each approximately odd multiples of the half-wavelength of the electron spin wave. The width W1 of the one-dimensional wire structure 10 is smaller than the half-wavelength of the electron spin wave. The first gate electrode 21 and the second gate electrode 22 can switch the applied first gate voltage and the second gate voltage HIGH and LOW, respectively. The first gate electrode 21 and the second gate electrode 22 are positioned in series along the one-dimensional wire structure 10. The distance L6 between the first gate electrode 21 and the second gate electrode 22 is approximately an integer multiple of the wavelength of the electron spin wave.

The logic operation element 9 is a two-logic input XOR logic operation element or a two-logic input XNOR logic operation element. Specifically, the HIGH and LOW of the gate voltages correspond to the first logic input and the HIGH and LOW of the gate voltages correspond to the second logic input.

First, assume that the distance L3 between the spin wave generator 30 and the output section 40 is approximately an even multiple of the half-wavelength of the electron spin wave, i.e., approximately an integer multiple of the wavelength.

The region R4, the region R6 and the region R8 are in the iPSH state. The region R5 is in the PSH state when the first gate voltage is HIGH and is in the iPSH state when the first gate voltage is LOW. The region R7 is in the PSH state when the second gate voltage is HIGH and is in the iPSH state when the second gate voltage is LOW.

Consider the following case in which the spin wave generator 30 is irradiated with right-handed circularly polarized light to generate an electron spin wave, upward, with phase 0. The phase state of the electron spin wave output from the output section 40 is described according to the HIGH/LOW of the first gate voltage and the second gate voltage.

### (In case of the first gate voltage = LOW and the second gate voltage = LOW)

In the region R4, the electrons propagate while maintaining coherent spin rotation.

In the region R5, the electrons propagate while maintaining coherent spin rotation.

In the region R6, the electrons propagate while maintaining coherent spin rotation.

In the region R7, the electrons propagate while maintaining coherent spin rotation.

In the region R8, the electrons propagate while maintaining coherent spin rotation.

Since the distance L3 is approximately an integer multiple of the wavelength of the electron spin wave, the phase state of the electron spin wave output from the output section 40 is approximately the same as that at the spin wave generator 30, i.e., the phase difference between the spin wave generator 30 and the output section 40 is approximately an integer multiple of 2π. Therefore, the output section 40 outputs an electron spin wave, upward, with phase 0.

### (In case of the first gate voltage = LOW and the second gate voltage = HIGH)

In the region R4, the electrons propagate while maintaining coherent spin rotation.

In the region R5, the electrons propagate while maintaining coherent spin rotation.

In the region R6, the electrons propagate while maintaining coherent spin rotation.

In the region R7, the electrons propagate without rotating the spin direction.

Since the length of the region R7, i.e., the length of the second gate electrode 22, is approximately an odd multiple of the half-wavelength of the electron spin wave, the phase of the electron spin wave is shifted by approximately an odd multiple of π, i.e., approximately a half-wavelength.

In the region R8, the electrons propagate while maintaining coherent spin rotation.

Since the distance L3 is approximately an integer multiple of the electron spin wave wavelength and the phase of the electron spin wave is shifted by approximately π in the region R7, the phase state of the electron spin wave output from output section 40 is approximately the opposite of the state at the spin wave generator 30, i.e., the phase difference between the spin wave generator 30 and output section 40 is approximately an odd multiple of π. Therefore, the output section 40 outputs an electron spin wave, downward, with phase π.

### (In case of the first gate voltage = HIGH and the second gate voltage = LOW)

In the region R4, the electrons propagate while maintaining coherent spin rotation.

In the region R5, the electrons propagate without rotating the spin direction.

Since the length of the region R5, i.e., the length of the first gate electrode 21, is approximately an odd multiple of the half-wavelength of the electron spin wave, the phase of the electron spin wave is shifted by approximately an odd multiple of π, i.e., approximately a half-wavelength.

In the region R6, the electrons propagate while maintaining coherent spin rotation.

In region R7, the electrons propagate while maintaining coherent spin rotation.

In the region R8, the electrons propagate while maintaining coherent spin rotation.

Since the distance L3 is approximately an integer multiple of the wavelength of the electron spin wave and the phase of the electron spin wave is shifted by approximately π in the region R5, the phase state of the electron spin wave output from output section 40 is approximately the opposite of the state at spin wave generator 30, i.e., the phase difference between the spin wave generator 30 and output section 40 is approximately an odd multiple of n. Therefore, the output section 40 outputs an electron spin wave, downward, with phase π.

### (In case of the first gate voltage = HIGH and the second gate voltage = HIGH)

In the region R4, the electrons propagate while maintaining coherent spin rotation.

In the region R5, the electrons propagate without rotating the spin direction.

Since the length of the region R5, i.e., the length of the first gate electrode 21, is approximately an odd multiple of the half-wavelength of the electron spin wave, the phase of the electron spin wave is shifted by approximately an odd multiple of π, i.e., approximately a half-wavelength.

In the region R6, the electrons propagate while maintaining coherent spin rotation.

In the region R7, the electrons propagate without rotating the spin direction.

Since the length of the region R7, i.e., the length of the second gate electrode 22, is approximately an odd multiple of the half-wavelength of the electron spin wave, the phase of the electron spin wave is shifted by approximately an odd multiple of π, i.e., approximately a half-wavelength.

In the region R8, the electrons propagate while maintaining coherent spin rotation.

Since the distance L3 is approximately an integer multiple of the wavelength of the electron spin wave and the phase of the electron spin wave is shifted by approximately π in the region R5 and the region R7, both the region R5 and the R7 together are shifted by approximately 2π, the phase state of the electron spin wave output from the output section 40 is approximately the same as that at the spin wave generator section 30, i.e., the phase difference between the spin wave generator 30 and the output section 40 is approximately an integer multiple of 2π. Therefore, the output section 40 outputs an electron spin wave, upward, with phase 0.

### Now assume the following.

The state of the first gate voltage HIGH corresponds to the logic value of the first input variable = 1,
the state of the first gate voltage LOW corresponds to the logic value of the first input variable = 0,
the state of the second gate voltage HIGH corresponds to the logic value of the second input variable = 1,
the state of the second gate voltage LOW corresponds to the logic value of the second input variable = 0,
a proposition is "true", i.e., the logical value = 1 when the state at the spin wave generator 30 and the phase state of the electron spin wave output from the output section 40 are opposite and
a proposition is "false", i.e., the logical value = 0 when the state at the spin wave generator 30 and the phase state of the electron spin wave output from the output section 40 are the same.

Then, the truth table is shown in Table 1.

### Table 1

**[Table 1]**

| FIRST VARIABLE / SWITCH 21S | SECOND VARIABLE / SWITCH 22S | TRUTH VALUE |
|---|---|---|
| 0 /OFF | 0/OFF | 0 |
| 0 /OFF | 1/ON | 1 |
| 1/ON | 0 /OFF | 1 |
| 1/ON | 1/ON | 0 |

Thus, by making the HIGH/LOW state of the first gate voltage correspond to the first logic input and the HIGH/LOW state of the second gate voltage correspond to the second logic input, an XOR logic operation element with two logic inputs in series can be realized.

Next, assume that the distance L3 between the spin wave generator 30 and the output section 40 is approximately an odd multiple of the half wavelength of the electron spin wave, i.e., approximately a half-integer multiple of the wavelength. In this case, it is clear that the logic is the converse of the case in which the distance L3 is approximately an even multiple of the half-wavelength of the electron spin wave.

Therefore, by making the distance L3 between the spin wave generator 30 and the output section 40 approximately an odd multiple of the half-wavelength of the electron spin wave, making the HIGH/LOW state of the first gate voltage correspond to the first logic input and making the HIGH/LOW state of the second gate voltage correspond to the second logic input, an XNOR logic operation element with two logic inputs in series can be realized.

### The eleventh embodiment

This embodiment is a logic device that comprises a logic operation element 7 of Figure 10 and a majority logic operation element that takes the phases of multiple electron spin waves as logic inputs and the phase of the electron spin wave on which these multiple electron spin waves are multiplexed as logic output. The majority logic operation element comprises a two-dimensional wire structure. The two-dimensional wire structure comprises a one-dimensional wire structure through which electron spin waves propagate, a branching point at which the one-dimensional wire structure branches to form two or more branching wires and a junction point at which the two or more branching wires merge to form a single one-dimensional wire structure.

According to this embodiment, any logic operation can be realized.

As described below, in the embodiment in which the distance is determined by projection in the X direction, no phase shift occurs even if the lengths in the XY plane from the branching point to the junction point of multiple one-dimensional wire structures are different. Therefore, the two-dimensional wire structure can be easily configured.

### The twelfth embodiment

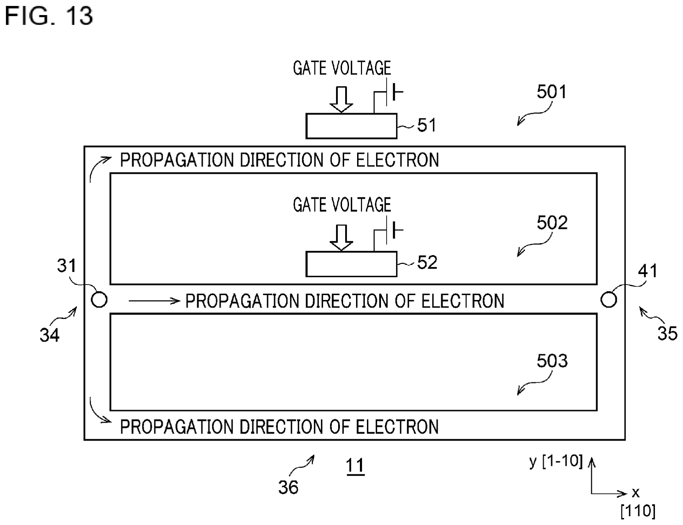

Figure 13 is a schematic diagram of an AND logic device 11 according to the twelfth embodiment. This embodiment is a logic device that combines three parallel logic inputs and majority logic. This logic device comprises a two-dimensional wire structure 36, a first gate electrode 51 and a second gate electrode 52. In the two-dimensional wire structure 36 , a one-dimensional wire structure comprising a material that, upon irradiation of light with a predetermined polarization state, generates electron spin waves with a phase corresponding to the polarization state branches to form three branching wires, i.e., a first branching wire 501, a second branching wire 502 and a third branching wire 503 at a branching point 34 and the three branching wires merge to form a single one-dimensional wire structure at a junction point 35. The first gate electrode 51 is positioned along part of the first branching wire 501. The second gate electrode 52 is positioned along part of the second branching wire 502. The two-dimensional wire structure 36 comprises a spin wave generator 31 and an output section 41. The spin wave generator 31 either generates electron spin waves by irradiating electrons in the two-dimensional wire structure 36 at or before the branching point 34 with optical signals or is input electron spin waves output from an adjacent one-dimensional wire structure. The output section 41 outputs an electron spin wave on which the electron spin wave propagated through the first branching wire 501, the electron spin wave propagated through the second branching wire 502 and the electron spin wave propagated through the third branching wire 503 at or after junction point 35 are multiplexed. The distance between the spin wave generator 31 and the output section 41 is approximately an integer multiple of the half-wavelength of the electron spin wave. In the first branching wire 501, a first gate electrode section is positioned along the first gate electrode 51. In the second branching wire 502, a second gate electrode section is positioned along the second gate electrode 52. The lengths of the first gate electrode and the second gate electrode are approximately odd multiples of the half-wavelength of the electron spin wave. The width of the one-dimensional wire structure is smaller than the half-wavelength of the electron spin wave. The electron spin wave before entering the first gate electrode section and the second gate electrode section from the spin wave generator 31 is in the iPSH state or the PSH state. The first gate electrode 51 and the second gate electrode 52 respectively can apply a first gate voltage that makes the electron spin wave into the PSH state and a second gate voltage that makes the electron spin wave into the iPSH state. Here, the branching point 34 coincides with the spin wave generator 31, the junction point 35 coincides with the output section 41 and the two-dimensional wire structure 36 coincides with the AND logic device 11 itself.

According to this embodiment, in a majority logic operation element with three parallel logic inputs, the AND logic device 11 with two logic inputs can be realized by fixing one logic input to the logic value 0. Furthermore, a NAND logic device can be realized by shifting the distance between the spin wave generator and the output section by half a wavelength.

### The thirteenth embodiment

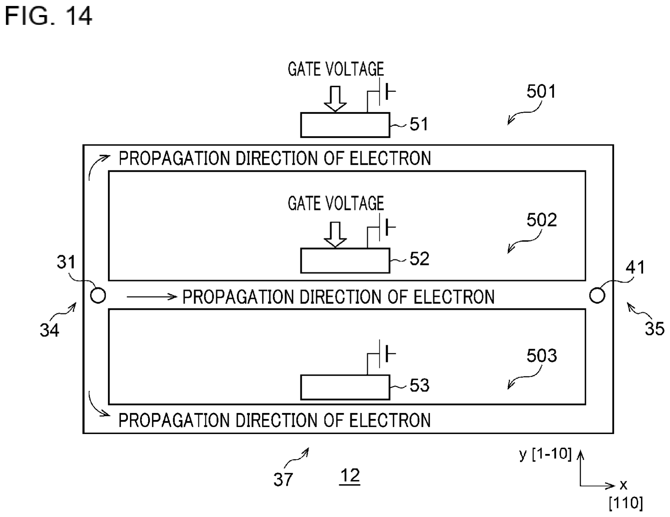

Figure 14 is a schematic diagram of an OR logic device 12 according to the thirteenth embodiment. This embodiment is a logic device that combines three parallel logic inputs and majority logic. This logic device comprises a two-dimensional wire structure 37, a first gate electrode 51, a second gate electrode 52 and a third gate electrode 53. In the two-dimensional wire structure 37, a one-dimensional wire structure comprising a material that, upon irradiation of light with a predetermined polarization state, generates electron spin waves with a phase corresponding to the polarization state branches to form three branching wires, i.e., a first branching wire 501, a second branching wire 502 and a third branching wire 503 at a branching point 34 and the three branching wires merge to form a single one-dimensional wire structure at a junction point 35. The first gate electrode 51 is positioned along part of the first branching wire 501. The second gate electrode 52 is positioned along part of the second branching wire 502. The third gate electrode 53 is positioned along part of the third branching wire 503. The two-dimensional wire structure 37 comprises a spin wave generator 31 and an output section 41. The spin wave generator 31 either generates electron spin waves by irradiating electrons in the two-dimensional wire structure 37 at or before the branching point 34 with optical signals or is input electron spin waves output from an adjacent one-dimensional wire structure. The output section 41 outputs an electron spin wave on which the electron spin wave propagated through the first branching wire 501, the electron spin wave propagated through the second branching wire 502 and the electron spin wave propagated through the third branching wire 503 at or after the junction point 35 are multiplexed. The distance between the spin wave generator 31 and the output section 41 is approximately an integer multiple of the half-wavelength of the electron spin wave. In the first branching wire 501, a first gate electrode section is positioned along the first gate electrode 51. In the second branching wire 502, a second gate electrode section is positioned along the second gate electrode 52. In the third branching wire 503, a third gate electrode section is positioned along the third gate electrode 53. The lengths of the first gate electrode, the second gate electrode and the third gate electrode are approximately odd multiples of the half-wavelength of the electron spin wave. The width of the one-dimensional wire structure is smaller than the half-wavelength of the electron spin wave. The electron spin wave before entering the first gate electrode section and the second gate electrode section from the spin wave generator 31 is in the iPSH state or the PSH state. The first gate electrode 51 and the second gate electrode 52 respectively can apply a first gate voltage that makes the electron spin wave into the PSH state and a second gate voltage that makes the electron spin wave into the iPSH state. The third gate electrodes 53 applies the first gate voltage that makes the electron spin wave into the PSH state. Here, the branching point 34 coincides with the spin wave generator 31, the junction point 35 coincides with the output section 41 and the two-dimensional wire structure 37 coincides with the OR logic device 12 itself.

According to this embodiment, in a majority logic operation element with three parallel logic inputs, the OR logic device with two logic inputs can be realized by fixing one logic input to the logic value 1. Furthermore, a NOR logic device can be realized by shifting the distance between the spin wave generator and the output section by half a wavelength.

### The fourteenth embodiment

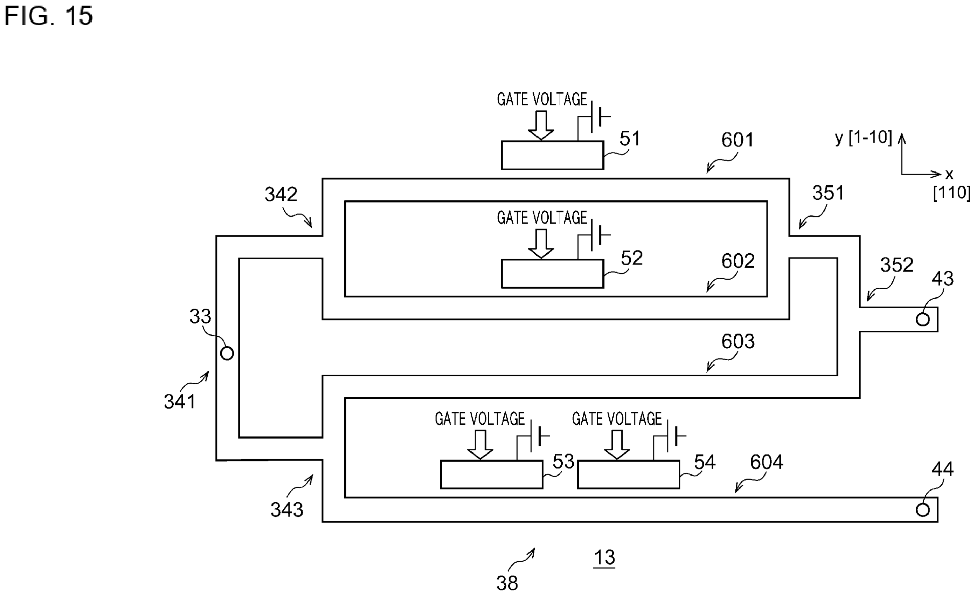

Figure 15 is a schematic diagram of a half-adder 13 according to the fourteenth embodiment. Namely, this embodiment is a logic device that constitutes a half-adder. In this logic device, a one-dimensional wire structure comprising a material that, upon irradiation of light with a predetermined polarization state, generates electron spin waves with a phase corresponding to the polarization state branches to form two one-dimensional wire structures at a first branching point 341. One of the two one-dimensional wire structures branches to form a first branching wire 601 and a second branching wire 602 at the second branching point 342. The other of the two one-dimensional wire structures branches to form a third branching wire 603 and a fourth branching wire 604 at the third branching point 343. As a result, a total of four branching wires is formed. The first branching wire 601 and the second branching wire 602 merge to form a single one-dimensional wire structure at a first junction point 351. Then the one-dimensional wire structure and the third branching wire 603 merge into one wire structure at a second junction point 352. The half-adder 13 comprises a two-dimensional wire structure 38, a first gate electrode 51, a second gate electrode 52, a third gate electrode 53 and a fourth gate electrode 54. The two-dimensional wire structure 38 is formed by a wire structure into which the first branching wire 601, the second branching wire 602 and the third branching wire 603, and the fourth branch wire 604 that does not merge with other branch wires. The first gate electrode 51 is positioned along part of the first branching wire 601. The second gate electrode 52 is positioned along part of the first branching wire 602. The third gate electrode 53 and the fourth gate electrode 54 are positioned along part of the fourth branching wire 604. The two-dimensional wire structure 38 comprises a spin wave generator 33, a first output section 43 and a second output section 44. The spin wave generator 33 either generates electron spin waves by irradiating electrons in the two-dimensional wire structure 38 at or before the first branching point 341 with optical signals or is input electron spin waves output from an adjacent one-dimensional wire structure. The first output section 43 outputs an electron spin wave on which the electron spin wave propagated through the first branching wire, the electron spin wave propagated through the second branching wire and the electron spin wave propagated through the third branching wire at or after the second junction point 352 are multiplexed. The second output section 44 outputs an electron spin wave that has propagated through the fourth branching wire 604. The distance between the spin wave generator 33 and the first output section 43 and the distance between the spin wave generator 33 and the second output section 44 are approximately integer multiples of the wavelength of the electron spin wave. In the first branching wire 601, a first gate electrode section is positioned along the first gate electrode 51. In the second branching wire 602, a second gate electrode section is positioned along the second gate electrode 52. In the fourth branching wire 604, a third gate electrode section along the third gate electrode 53 and a fourth gate electrode section along the fourth gate electrode 54 are positioned in series. The length of the gate electrodes is approximately an odd multiple of the half-wavelength of the electron spin wave. The width of the one-dimensional wire structure is smaller than the half-wavelength of the electron spin wave. The electron spin wave before entering the first gate electrode section, the second gate electrode section and the third gate electrode section from the spin wave generator 33 is in the iPSH state or the PSH state. The first gate electrode 51, the second gate electrode 52, the third gate electrode 53 and the fourth gate electrode 54 respectively can apply a first gate voltage that makes the electron spin wave into the PSH state and a second gate voltage that makes the electron spin wave into the iPSH state. Here, the first branching point 341 coincides with the spin wave generator 33 and the two-dimensional wire structure 38 coincides with the half-adder 13 itself.

In the above embodiment, the one-dimensional wire structure branches into two branching wires at the first branching point 341 and further branches into two or more at the second branching point 342 and the third branching point 343, however it is not limited to this, for example, it may branch into four branching wires at the branching point.

For example, the phase state of the electron spin wave output from the first output section 43 may be the upper bit of a 2-bit binary number, and the phase state of the electron spin wave output from the second output section 44 may be the lower bit of a 2-bit binary number. One of the binary numbers to be added may be input to the first gate electrode 51 and the third gate electrode 53, and the other of the binary numbers to be added to the second gate electrode 52 and the fourth gate electrode 54.

According to this embodiment, a half-adder based on the logic operation and interference nature of the wave can be realized by allowing logic operations based on high and low voltage levels to be performed on the optical input signal while maintaining the interference nature of the wave.

### The fifteenth embodiment

A logic operation element 1 according to the fifteenth embodiment is described using Figure 2. This logic operation element 1 operates as a NOT logic device. The logic operation element 1 comprises a one-dimensional wire structure 10 and a gate electrode 20. The one-dimensional wire structure 10 comprises a spin wave generator 30 and an output section 40. The spin wave generator 30 generates electron spin waves by irradiating electrons in the one-dimensional wire structure with optical signals. The output section 40 outputs the electron spin wave propagated through the one-dimensional wire structure 10. The gate electrode 20 is positioned between the spin wave generator 30 and the output section 40 along the one-dimensional wire structure 10.

For example, the polarization state of the irradiated light may be either right-handed circularly polarized or left-handed circularly polarized. When such light is irradiated to the spin wave generator 30, the spin wave generator 30 generates an electron spin wave with phase 0 for right-handed circularly polarized light and an electron spin wave with phase π for left-handed circularly polarized light. Hereafter, the electron spin wave of phase 0 is associated with the logic value "0" and the electron spin wave of phase π is associated with the logic value "1". Thus, in this case, the right-handed circular polarization of the irradiated light corresponds to the logic value 0, and the left-handed circular polarization of the irradiated light corresponds to the logic value 1.

The gate electrode 20 applies a gate voltage such that α = 0 to a portion of the one-dimensional wire structure 10 with β = 0, thereby converting the state in which only the Rashba interaction is active as a spin-orbit interaction to the electrons in the one-dimensional wire structure 10 and the state in which no interaction is active to each other. In the example in Figure 2, the distance L1 between the spin wave generator 30 and the output section 40 is approximately an integer multiple of the wavelength of the electron spin wave propagating in the one-dimensional wire structure 10. The Region R1 and the region R3 of the one-dimensional wire structure 10 are not directly under the gate electrode 20, therefore no gate voltage is applied to these regions. On the other hand, the region R2 is directly under the gate electrode 20, therefore the gate voltage is applied to this region. For example, when the region R1 was in a state in which only the Rashba interaction is active as a spin-orbit interaction to the electrons in the one-dimensional wire structure 10, the region R2 is converted to a state in which no interaction is active, and the region R3 returns to a state in which only the Rashba interaction is active again.

The distance L1 between the spin wave generator 30 and the output section 40 is approximately an integer multiple of the wavelength of the electron spin wave propagating in the one-dimensional wire structure 10. The length L2 of the gate electrode 20 is approximately an odd multiple of the half wavelength of the electron spin wave. The width W1 of the one-dimensional wire structure is less than the half wavelength of the electron spin wave.

The other configuration and operation of the logic device 1 is similar to the NOT logic device according to the second embodiment.

In the InGaAs/GaAs heterostructure, a two-dimensional electron gas is formed near the interface. The spin-orbit interaction when an electric field is applied perpendicular to this system is the Rashba interaction. As described above, the phase of the electron spin wave can be controlled by applying a gate voltage exceeding the threshold value to the gate electrode 20, and converting the state in which only the Rashba interaction is active as the spin-orbit interaction to the electrons in the one-dimensional wire structure 10 and the state in which no interaction is active each other, similar to the conversion between the PSH state and the iPSH state, i.e., to the second embodiment.

### The sixteenth embodiment

A logic operation element 8 according to the sixteenth embodiment is described using Figure 11. This logic operation element 8 operates as a NOT logic device. The logic operation element 8 comprises a one-dimensional wire structure 10 and a gate electrode 24. The one-dimensional wire structure 10 comprises a spin wave generator 33 and an output section 45.

The one-dimensional wire structure 10 comprises a material that, upon irradiation of light having a predetermined polarization state, generates an electron spin wave having a phase corresponding to this polarization state. The spin wave generator 33 generates electron spin waves by irradiating electrons in the one-dimensional wire structure with optical signals. The output section 45 outputs the electron spin wave propagated through the one-dimensional wire structure 10.

The gate electrode 24 applies a gate voltage such that α = β = 0 to a portion of the one-dimensional wire structure 10 with β = 0, thereby converting the state in which only the Rashba interaction is active as a spin-orbit interaction to the electrons in the one-dimensional wire structure 10 and the state in which no interaction is active to each other. In the example in Figure 11, the distance L1 between the spin wave generator 33 and the output section 45 is approximately an integer multiple of the wavelength of the electron spin wave propagating in the one-dimensional wire structure 10. The Region R1 and the region R3 of the one-dimensional wire structure 10 are not directly under the gate electrode 20, therefore no gate voltage is applied to these regions. On the other hand, the region R2 is directly under the gate electrode 20, therefore the gate voltage is applied to this region. For example, when the region R1 was in a state in which only the Rashba interaction is active as a spin-orbit interaction to the electrons in the one-dimensional wire structure 10, the region R2 is converted to a state in which no interaction is active, and the region R3 returns to a state in which only the Rashba interaction is active again.

The other configuration and operation of the logic device 8 is similar to the NOT logic device according to the ninth embodiment.

Thus, the phase of the electron spin wave can be controlled by applying a gate voltage such that α = β = 0 to the gate electrode 24, and converting the state in which only the Rashba interaction is active as the spin-orbit interaction to the electrons in the one-dimensional wire structure 10 and the state in which no interaction is active each other, similar to the conversion between the PSH state and the iPSH state, i.e., to the ninth embodiment.

The invention has been described above in terms of the embodiments. It is understood by those skilled in the art that these embodiments are examples, that various variations are possible in the combination of their respective components and respective processing processes, and that such variations are also within the scope of the invention.

The NOT logic device, the AND logic device and the OR logic device described in the embodiments realize the basic functions of digital circuits. By combining these basic functions with majority logic while maintaining the wave nature of the electron spin wave, various functions can be realized.

In understanding the technical ideas abstracted from the embodiments and variations, the technical ideas should not be interpreted as limited to the contents of the embodiments and variations. The aforementioned embodiments and variations are merely concrete examples, and many design changes, such as changes, additions, and deletions of components, are possible. In the embodiments, the contents where such design changes are possible are emphasized with the notation "embodiments". However, design changes are also allowed for content without such notation.

### INDUSTRIAL APPLICABILITY

The technology of the present disclosure can be used in the fields of optical communications, photoelectric conversion systems, network computers, and the like.

### REFERENCE SIGNS LIST

- 1A: logic operation element,
- 1: NOT logic device,
- 2: Switchable NOT logic device,
- 3: XOR logic device,
- 4: AND logic devices,
- 5: OR logic devices,
- 6: half-adder,
- 7: logic operation element,
- 8: logic operation element,
- 9: logic operation element,
- 10: one-dimensional wire structure,
- 11: AND logic devices,
- 12: OR logic device,
- 13: half-adder,
- 103: third NOT logic device,
- 20A: gate electrode,
- 20: gate electrode,
- 21: gate electrode,
- 22: gate electrode,
- 23: gate electrode,
- 24: gate electrode,
- 201: first switchable NOT logic device,
- 202: second switchable NOT logic device,
- 20S: switch,
- 21S: switch,
- 22S: switch,
- 302: second XOR logic device,
- 30: spin wave generator,
- 31: spin wave generator,
- 32: spin wave generator,
- 33: spin wave generator,
- 34: branching point,
- 341: first branching point,
- 342: second branching point,
- 343: third branching point,
- 35: junction point,
- 351: first junction point,
- 352: second junction point,
- 36: two-dimensional wire structure,
- 37: two-dimensional wire structure,
- 38: two-dimensional wire structure,
- 401: first AND logic device,
- 40: output section,
- 41: output section,
- 42: output section,
- 43: output section of first AND logic device,
- 44: output section of second XOR logic device,
- 45: output section,
- 51: first gate electrode,
- 52: second gate electrode,
- 53: third gate electrode,
- 54: fourth gate electrode,
- 501: first branching wire,
- 502: second branching thin wire,
- 503: third branching thin wire,
- 601: first branching thin wire,
- 602: second branching thin wire,
- 603: third branching thin wire,
- 604: fourth branching thin wire,
- 703: third one-dimensional wire structure,
- L1: distance between spin wave generator and output section,
- L2: length of gate electrode,
- L3: distance between spin wave generator and output section,
- L4: length of first gate electrode,
- L5: length of second gate electrode,
- L6: distance between first gate electrode and second gate electrode,
- W1: width of one-dimensional wire structure,
- R1: region,
- R2: region,
- R3: region,
- R4: region,
- R5: region,
- R6: region,
- R7: region,
- R8: region.

## Claims

1. A logic operation element comprising:
a one-dimensional wire structure through which an electron spin wave propagates; and
a gate electrode along part of the one-dimensional wire structure,
wherein the logic input is the phase state of the electron spin wave before propagating through the one-dimensional wire structure and
wherein the logic output is the phase state of the electron spin wave after propagation through the one-dimensional wire structure.

2. A NOT logic device comprising:
the logic operation element according to Claim 1,
wherein the one-dimensional wire structure comprises a material that, upon irradiation of light having a predetermined polarization state, generates an electron spin wave having a phase corresponding to the polarization state,
wherein the one-dimensional wire structure comprises a spin wave generator and an output section,
wherein the spin wave generator either generates electron spin waves by irradiating electrons in the one-dimensional wire structure with optical signals or is input electron spin waves output from an adjacent one-dimensional wire structure,
wherein the output section outputs the electron spin wave that has propagated through the one-dimensional wire structure,
wherein in the one-dimensional wire structure, a gate electrode section along the gate electrode is positioned between the spin wave generator and the output section,
wherein the distance between the spin wave generator and the output section is approximately an integer multiple of the wavelength of the electron spin wave,
wherein the length of the gate electrode is approximately an odd multiple of the half wavelength of the electron spin wave,
wherein the width of the one-dimensional wire structure is smaller than half the wavelength of the electron spin wave,
wherein the electron spin wave before entering the gate electrode section from the spin wave generator is in the iPSH state or the PSH state,
wherein the gate electrode can apply a gate voltage that makes the electron spin wave at the gate electrode section into the PSH state when the electron spin wave before entering the gate electrode section from the spin wave generator is in the iPSH state,
wherein the gate electrode can apply a gate voltage that makes the electron spin wave at the gate electrode section into the iPSH state when the electron spin wave before entering the gate electrode section from the spin wave generator is in the PSH state,
wherein the logic input is the phase state of the electron spin wave at the spin wave generator and
wherein the logic output is the phase state of the electron spin wave at the output section.

3. A switchable NOT logic device comprising:
the logic operation element according to Claim 1,
wherein the one-dimensional wire structure comprises a material that, upon irradiation of light having a predetermined polarization state, generates an electron spin wave having a phase corresponding to the polarization state,
wherein the one-dimensional wire structure comprises a spin wave generator and an output section,
wherein the spin wave generator either generates electron spin waves by irradiating electrons in the one-dimensional wire structure with optical signals or is input electron spin waves output from an adjacent one-dimensional wire structure,
wherein the output section outputs the electron spin wave that has propagated through the one-dimensional wire structure,
wherein in the one-dimensional wire structure, a gate electrode section along the gate electrode is positioned between the spin wave generator and the output section,
wherein the distance between the spin wave generator and the output section is approximately an integer multiple of the wavelength of the electron spin wave,
wherein the length of the gate electrode is approximately an odd multiple of the half wavelength of the electron spin wave,
wherein the width of the one-dimensional wire structure is smaller than half the wavelength of the electron spin wave,
wherein the electron spin wave before entering the gate electrode section from the spin wave generator is in the iPSH state or the PSH state,
wherein the switchable NOT logic device further comprises a switch that switches the voltage applied to the gate electrode between a first gate voltage that makes the electron spin wave into the PSH state and a second gate voltage that makes the electron spin wave into the iPSH state,
wherein the logic input is the phase state of the electron spin wave at the spin wave generator,
wherein the logic output is the phase state of the electron spin wave at the output section and
wherein the switch is switchable between NOT logic and identity logic.

4. An XOR logic device comprising:
two switchable NOT logic devices according to Claim 3,
wherein the two switchable NOT logic devices are connected in series in the first stage and the second stage,
wherein the spin wave generator of the switchable NOT logic device in the first stage is the overall spin wave generator,
wherein the output section of the switchable NOT logic device in the first stage is common to the spin wave generator of the switchable NOT logic device in the second stage,
wherein the output section of the switchable NOT logic device in the second stage is the overall output section,
wherein the logic input is whether the voltage applied to the gate electrodes of the two switchable NOT logic devices is the first gate voltage that makes the electron spin wave into the PSH state or the second gate voltage that makes the electron spin wave into the iPSH state and
wherein the logic output is the phase state of the electron spin wave at the overall output section.

5. An AND logic device comprising:
two switchable NOT logic devices according to Claim 3; and
one the one-dimensional wire structure,
wherein three of the two switchable NOT logic devices and the one one-dimensional wire structure are connected in parallel,
wherein the spin wave generators of the two switchable NOT logic devices and the spin wave generator of the one-dimensional wire structure are common,
wherein the output sections of the two switchable NOT logic devices and the output section the one-dimensional wire structure are common,
wherein the logic input is whether the voltage applied to the gate electrodes of the two switchable NOT logic devices is the first gate voltage that makes the electron spin wave into the PSH state or the second gate voltage that makes the electron spin wave into the iPSH state and
wherein the logic output is the phase state of the electron spin wave at the output section.

6. An OR logic device comprising:
two switchable NOT logic devices according to Claim 3; and
one NOT logic devices according to Claim 2,
wherein three of the two switchable NOT logic devices and the one NOT logic device are connected in parallel,
wherein the spin wave generators of the two switchable NOT logic devices and the spin wave generator of the NOT logic device are common,
wherein the output sections of the two switchable NOT logic devices and the output section of the NOT logic device are common,
wherein the logic input is whether the voltage applied to the gate electrodes of the two switchable NOT logic devices is the first gate voltage that makes the electron spin wave into the PSH state or the second gate voltage that makes the electron spin wave into the iPSH state and
wherein the logic output is the phase state of the electron spin wave at the output section.

7. A half-adder comprising:
the AND logic devices according to Claim 5;
and the XOR logic devices according to Claim 4,
wherein the AND logic device and the XOR logic device are connected in parallel,
wherein the spin wave generator of the AND logic device and the spin wave generator of the XOR logic device are common,
wherein the output section of the AND logic device and the output section of the XOR logic device are separate,
wherein each of 1-bit binary inputs to be added is whether the voltage applied to the gate electrodes of the two switchable NOT logic devices of the AND logic device is the first gate voltage that makes the electron spin wave into the PSH state or the second gate voltage that makes the electron spin wave into the iPSH state,
wherein the upper bit of the 2-bit binary output is the phase state of the electron spin wave at the output section of the AND logic device,
wherein the each of 1-bit binary inputs to be added is whether the voltage applied to the gate electrodes of the two switchable NOT logic devices of the XOR logic device is the first gate voltage or the second gate voltage and
wherein the lower bit of the 2-bit binary output is the phase state of the electron spin wave at the output section of the XOR logic device.

8. A logic operation element comprising:
a one-dimensional wire structure through which an electron spin wave propagates; and
a gate electrode along part of the one-dimensional wire structure,
wherein the logic input is the high and low of the gate voltages applied to the gate electrode and
wherein the logic output is the phase state of the electron spin wave.

9. The logic operation element according to Claim 8,
wherein the one-dimensional wire structure comprises a material that, upon irradiation of light having a predetermined polarization state, generates an electron spin wave having a phase corresponding to the polarization state,
wherein the one-dimensional wire structure comprises a spin wave generator and an output section,
wherein the spin wave generator either generates electron spin waves by irradiating electrons in the one-dimensional wire structure with optical signals or is input electron spin waves output from an adjacent one-dimensional wire structure,
wherein the output section outputs the electron spin wave that has propagated through the one-dimensional wire structure,
wherein in the one-dimensional wire structure, a gate electrode section along the gate electrode is positioned between the spin wave generator and the output section,
wherein the distance between the spin wave generator and the output section is approximately an integer multiple of the wavelength of the electron spin wave,
wherein the length of the gate electrode is approximately an odd multiple of the half wavelength of the electron spin wave,
wherein the width of the one-dimensional wire structure is smaller than half the wavelength of the electron spin wave,
wherein the electron spin wave before entering the gate electrode section from the spin wave generator is in the iPSH state or the PSH state,
wherein the gate electrode can apply a first gate voltage that makes the electron spin wave into the PSH state and a second gate voltage that makes the electron spin wave into the iPSH state.

10. The logic operation element according to Claim 8,
wherein the one-dimensional wire structure comprises a material that, upon irradiation of light having a predetermined polarization state, generates an electron spin wave having a phase corresponding to the polarization state,
wherein the gate electrode comprises a first gate electrode and a second gate electrode,
wherein the one-dimensional wire structure comprises a spin wave generator and an output section,
wherein the spin wave generator either generates electron spin waves by irradiating electrons in the one-dimensional wire structure with optical signals or is input electron spin waves output from an adjacent one-dimensional wire structure,
wherein the output section outputs the electron spin wave that has propagated through the one-dimensional wire structure,
wherein in the one-dimensional wire structure, a first gate electrode section along a first gate electrode and a second gate electrode section along a second gate electrode are positioned in series between the spin wave generator and the output section,
wherein the distance between the spin wave generator and the output section is approximately an integer multiple of the half wavelength of the electron spin wave,
wherein the lengths of the first gate electrode and the second gate electrode are each approximately odd multiples of the half wavelength of the electron spin wave,
wherein the distance between the first gate electrode and the second gate electrode is approximately an integer multiple of the wavelength of the electron spin wave,
wherein the width of the one-dimensional wire structure is smaller than half the wavelength of the electron spin wave,
wherein the electron spin wave before entering the first gate electrode section from the spin wave generator is in the iPSH state or the PSH state and
wherein the first gate electrode and the second gate electrode can apply a first gate voltage that makes the electron spin wave into the PSH state and a second gate voltage that makes the electron spin wave into the iPSH state, respectively.

11. A logic device comprising:
the logic operation element according to claim 8; and
a majority logic element,
wherein the logic input are phase states of a plurality of electron spin waves,
wherein the logic output is the phase state of the electron spin wave on which the plurality of electron spin waves are multiplexed,
wherein the majority logic element comprises a one-dimensional wire structure through which an electron spin wave propagates and a two-dimensional wire structure and
wherein the two-dimensional wire structure comprises a branching point at which the one-dimensional wire structure branches to form two or more branching wires and a junction point at which the two or more branching wires merge to form a single one-dimensional wire structure.

12. The logic device according to Claim 11,
wherein the one-dimensional wire structure comprises a material that, upon irradiation of light having a predetermined polarization state, generates an electron spin wave having a phase corresponding to the polarization state,
wherein at the branching point, the one-dimensional wire structure branches to form three branching wires of a first branching wire, a second branching wire and a third branching wire,
wherein at the junction point, three branching wires merge to form one one-dimensional wire structure,
wherein the logic device further comprises a first logic operation element and a second logic operation element,
wherein the first logic operation element comprises part of the first branching wire and a first gate electrode along the part of the first branching wire,
wherein the second logic operation element comprises part of the second branching wire and a second gate electrode along the part of the second branching wire,
wherein the two-dimensional wire structure comprises a spin wave generator and an output section,
wherein the spin wave generator either generates electron spin waves by irradiating electrons in the two-dimensional wire structure at or before the branching point with optical signals or is input electron spin waves output from an adjacent one-dimensional wire structure,
wherein the output section outputs an electron spin wave on which the electron spin wave propagated through the first branching wire, the electron spin wave propagated through the second branching wire and the electron spin wave propagated through the third branching wire at or after junction point are multiplexed,
wherein the distance between the spin wave generator and the output section is approximately an integer multiple of the half-wavelength of the electron spin wave,
wherein in the first branching wire, a first gate electrode section is positioned along the first gate electrode,
wherein in the second branching wire, a second gate electrode section is positioned along the second gate electrode,
wherein the lengths of the first gate electrode and the second gate electrode are approximately odd multiples of the half-wavelength of the electron spin wave,
wherein the width of the one-dimensional wire structure is smaller than the half-wavelength of the electron spin wave,
wherein the electron spin wave before entering the first gate electrode section and the second gate electrode section from the spin wave generator is in the iPSH state or the PSH state, and
wherein the first gate electrode and the second gate electrode respectively can apply a first gate voltage that makes the electron spin wave into the PSH state and a second gate voltage that makes the electron spin wave into the iPSH state.

13. The logic device according to Claim 11,
wherein the one-dimensional wire structure comprises a material that, upon irradiation of light having a predetermined polarization state, generates an electron spin wave having a phase corresponding to the polarization state,
wherein at the branching point, the one-dimensional wire structure branches to form three branching wires of a first branching wire, a second branching wire and a third branching wire,
wherein at the junction point, three branching wires merge to form one one-dimensional wire structure,
wherein the logic device further comprises a first logic operation element, a second logic operation element and a third logic operation element,
wherein the first logic operation element comprises part of the first branching wire and a first gate electrode along the part of the first branching wire,
wherein the second logic operation element comprises part of the second branching wire and a second gate electrode along the part of the second branching wire,
wherein the third logic operation element comprises part of the third branching wire and a third gate electrode along the part of the third branching wire,
wherein the two-dimensional wire structure comprises a spin wave generator and an output section,
wherein the spin wave generator either generates electron spin waves by irradiating electrons in the two-dimensional wire structure at or before the branching point with optical signals or is input electron spin waves output from an adjacent one-dimensional wire structure,
wherein the output section outputs an electron spin wave on which the electron spin wave propagated through the first branching wire, the electron spin wave propagated through the second branching wire and the electron spin wave propagated through the third branching wire at or after junction point are multiplexed,
wherein the distance between the spin wave generator and the output section is approximately an integer multiple of the half-wavelength of the electron spin wave,
wherein in the first branching wire, a first gate electrode section is positioned along the first gate electrode,
wherein in the second branching wire, a second gate electrode section is positioned along the second gate electrode,
wherein in the third branching wire, a third gate electrode section is positioned along the second gate electrode,
wherein the lengths of the first gate electrode, the second gate electrode and the third gate electrode are approximately odd multiples of the half-wavelength of the electron spin wave,
wherein the width of the one-dimensional wire structure is smaller than the half-wavelength of the electron spin wave,
wherein the electron spin wave before entering the first gate electrode section, the second gate electrode section and the third gate electrode section from the spin wave generator is in the iPSH state or the PSH state, and
wherein the first gate electrode, the second gate electrode and the third gate electrode respectively can apply a first gate voltage that makes the electron spin wave into the PSH state and a second gate voltage that makes the electron spin wave into the iPSH state.

14. The logic device according to Claim 11,
wherein the one-dimensional wire structure comprises a material that, upon irradiation of light having a predetermined polarization state, generates an electron spin wave having a phase corresponding to the polarization state,
wherein at the branching point, the one-dimensional wire structure branches to form four branching wires of a first branching wire, a second branching wire, a third branching wire and a fourth branching wire,
wherein at the junction point, three branching wires of the first branching wire, a second branching wire and a third branching wire merge to form one one-dimensional wire structure,
wherein the fourth branching wire forms a one-dimensional wire structure that does not merge with other branching wires,
wherein the logic device further comprises a first logic operation element, a second logic operation element, a third logic operation element and a fourth logic operation element,
wherein the first logic operation element comprises part of the first branching wire and a first gate electrode along the part of the first branching wire,
wherein the second logic operation element comprises part of the second branching wire and a second gate electrode along the part of the second branching wire,
wherein the third logic operation element comprises part of the fourth branching wire and a third gate electrode along the part of the fourth branching wire,
wherein the fourth logic operation element comprises other part of the fourth branching wire and a fourth gate electrode along the other part of the fourth branching wire,
wherein the two-dimensional wire structure comprises a spin wave generator, a first output section and a second output section,
wherein the spin wave generator either generates electron spin waves by irradiating electrons in the two-dimensional wire structure at or before the branching point with optical signals or is input electron spin waves output from an adjacent one-dimensional wire structure,
wherein the first output section outputs an electron spin wave on which the electron spin wave propagated through the first branching wire, the electron spin wave propagated through the second branching wire and the electron spin wave propagated through the third branching wire at or after junction point are multiplexed,
wherein the second output section outputs an electron spin wave propagated through the fourth branching wire,
wherein the distance between the spin wave generator and the first output section, and the distance between the spin wave generator and the second output section are approximately an integer multiple of the half-wavelength of the electron spin wave,
wherein in the first branching wire, a first gate electrode section is positioned along the first gate electrode,
wherein in the second branching wire, a second gate electrode section is positioned along the second gate electrode,
wherein in the fourth branching wire, a third gate electrode section along the third gate electrode and a fourth gate electrode section along the fourth gate electrode are positioned in series,
wherein the lengths of the first gate electrode, the second gate electrode, the third gate electrode and the fourth gate electrode are approximately odd multiples of the half-wavelength of the electron spin wave,
wherein the width of the one-dimensional wire structure is smaller than the half-wavelength of the electron spin wave,
wherein the electron spin wave before entering the first gate electrode section, the second gate electrode section and the third gate electrode section from the spin wave generator is in the iPSH state or the PSH state, and
wherein the first gate electrode, the second gate electrode, the third gate electrode and the fourth gate electrode respectively can apply a first gate voltage that makes the electron spin wave into the PSH state and a second gate voltage that makes the electron spin wave into the iPSH state.

15. A switchable NOT logic device that is switchable between NOT logic and identity logic comprising:
the logic operation element according to Claim 1,
wherein the one-dimensional wire structure comprises a material that, upon irradiation of light having a predetermined polarization state, generates an electron spin wave having a phase corresponding to the polarization state,
wherein the gate electrode can apply a first gate voltage and a second gate voltage,
wherein the first gate voltage makes the state in the one-dimensional wire structure to the state in which only the Rashba interaction is active as a spin-orbit interaction to the electrons,
wherein the second gate voltage makes the state in the one-dimensional wire structure to the state in which no interaction is active,
wherein the one-dimensional wire structure comprises a spin wave generator and an output section,
wherein the spin wave generator either generates electron spin waves by irradiating electrons in the one-dimensional wire structure with optical signals or is input electron spin waves output from an adjacent one-dimensional wire structure,
wherein the output section outputs the electron spin wave that has propagated through the one-dimensional wire structure,
wherein the gate electrode is positioned between the spin wave generator and the output section along the one-dimensional wire structure,
wherein the distance between the spin wave generator and the output section is approximately an integer multiple of the wavelength of the electron spin wave,
wherein the length of the gate electrode is approximately an odd multiple of the half wavelength of the electron spin wave,
wherein the width of the one-dimensional wire structure is smaller than half the wavelength of the electron spin wave,
wherein the logic input is the phase state of the electron spin wave at the spin wave generator and
wherein the logic output is the phase state of the electron spin wave at the output section.

16. The logic operation element according to Claim 8,
wherein the one-dimensional wire structure comprises a material that, upon irradiation of light having a predetermined polarization state, generates an electron spin wave having a phase corresponding to the polarization state,
wherein the one-dimensional wire structure comprises a spin wave generator and an output section,
wherein the spin wave generator either generates electron spin waves by irradiating electrons in the one-dimensional wire structure with optical signals or is input electron spin waves output from an adjacent one-dimensional wire structure,
wherein the output section outputs the electron spin wave that has propagated through the one-dimensional wire structure,
wherein in the one-dimensional wire structure, a gate electrode section along the gate electrode is positioned between the spin wave generator and the output section,
wherein the distance between the spin wave generator and the output section is approximately an integer multiple of the half wavelength of the electron spin wave,
wherein the length of the gate electrode is approximately an odd multiple of the half-wavelength of the electron spin wave,
wherein the width of the one-dimensional wire structure is smaller than the half-wavelength of the electron spin wave,
wherein the electron spin wave before entering the gate electrode section from the spin wave generator is in the state in which only the Rashba interaction is active as a spin-orbit interaction to the electrons,
wherein the gate electrode can apply a first gate voltage and a second gate voltage,
wherein the first gate voltage makes the state in the one-dimensional wire structure to the state in which only the Rashba interaction is active as a spin-orbit interaction to the electrons and
wherein the second gate voltage makes the state in the one-dimensional wire structure to the state in which no interaction is active.
